Europäisches Patentamt

European Patent Office

Office européen des brevets

(19)

(11) **EP 0 702 476 A2**

(12) **EUROPEAN PATENT APPLICATION**

(43) Date of publication:
20.03.1996 Bulletin 1996/12

(51) Int. Cl.$^6$: **H04L 25/48**, H04L 5/22,
H04L 1/00, H03M 13/00

(21) Application number: 95111926.2

(22) Date of filing: 28.07.1995

(84) Designated Contracting States:
**DE FR GB NL**

(30) Priority: **29.07.1994 JP 178608/94**

(71) Applicant: **KABUSHIKI KAISHA TOSHIBA**
**Kawasaki-shi (JP)**

(72) Inventor: **Okita, Shigeru,**
**c/o Intellectual Prop. Div.**
**Minato-ku, Tokyo 105 (JP)**

(74) Representative: **Henkel, Feiler, Hänzel & Partner**
**Möhlstrasse 37**
**D-81675 München (DE)**

(54) **Multilevel weighted transmission method and multilevel weighted transmission and reception apparatus**

(57)   According to this invention, there are provided a multilevel weighted transmission method which allows error correction encoders to be reduced to one without error propagation and an apparatus using this method. The multilevel weighted transmission method is such that a plurality of hierarchic information source data strings are subjected to different multilevel weighted coding and modulation by a trellis-coded modulation scheme and the resulting strings are transmitted, and on the reception side, the received signal is subjected to the multilevel weighted demodulation and decoding according to the transmission side to obtain the original hierarchic information source data strings. When the specific first subsets are allocated to the hierarchic levels of the transmission channel in the multilevel weighted transmission and time-division multiplexed at a predetermined ratio, the order of time-division multiplexing the hierarchic levels of the transmission channel is ascending order of the quality of transmission error characteristic.

WEIGHTING TRANSMISSION APPARATUS

WEIGHTING RECEPTION APPARATUS

F I G. 3

EP 0 702 476 A2

## Description

This invention relates to a multilevel weighted transmission method which enables a reduction in the circuit scale of coding and decoding equipment and a transmission and reception apparatus using the multilevel weighted transmission method.

In general, when digitized video or audio information is transmitted, transmission errors can take place on account of the influence of noise generated on the transmission path. To restore the information from the image with transmission errors, error correction techniques are used.

At first, the error correction techniques were developed independently from modulation techniques. Recently, there have been strong demands toward a much greater transmission capacity under the band restrictions, and modulation techniques now in use range from BPSK, QPSK to 16QAM, and even to higher-level modulation schemes.

In this situation, more excellent error correction techniques have been wanted. One that meets such a demand is a coding modulation scheme achieved by optimally combining modulation techniques with error correction techniques. G. Ungerboeck proposed trellis-coded modulation (hereinafter, abbreviated as TCM) using convolutional coding for the first time. This has been described in reference [1]: "Trellis-Coded Modulation with Redundant Signal Sets Part I: Introduction," IEEE Commun., vol. 25, 1987.

In such a development of error correction techniques, rapid degradation of transmission quality involved in digital transmission has been regarded as a problem. Specifically, in analog transmission, the transmission quality to noise deteriorates gently on the transmission path, whereas in digital transmission, the transmission quality degrades so sharply when the reception level drops below a specific value, for example, that error correction does not work at all. This means that in the case of mobile radio reception where the reception conditions change greatly from hour to hour, as the mobile terminal moves here and there, communication service is frequently not available at all. This is a serious problem.

To overcome the problem, transmission channel coding techniques for graceful degradation have been proposed which perform more powerful error correction on more important information by partitioning information source signals, such as video and audio signals, into a suitable number of levels hierarchically according to the degree of their importance, and allocating the level of error correction according to the degree of importance.

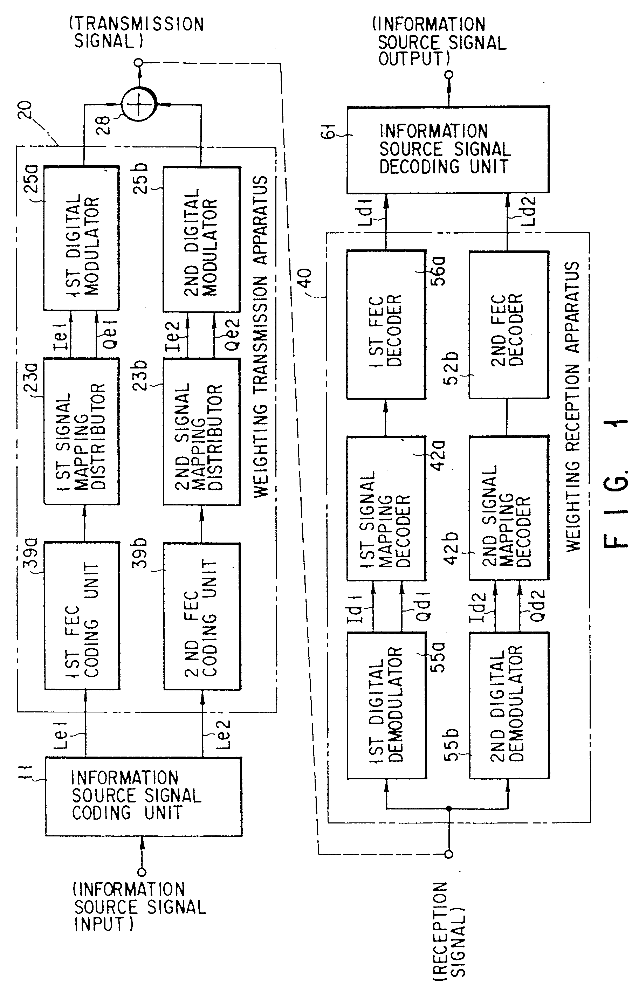

FIG. 1 shows an example of a conventional transmission channel coding and decoding apparatus with the function of giving a weight to each level of hierarchy. In FIG. 1, the information source input signal is partitioned by an information source signal coding unit 11 into more important information Le2 and less important information Le1 (in this example, the number of hierarchic levels is 2).

The pieces of information Le1 and Le2 undergo a coding process for error correction at a first FEC (Forward Error Correction) coding unit 39a and a second FEC coding unit 39b, respectively. Here, it is assumed that the second FEC coding unit 39b effects heavier coding than the first FEC coding unit 39a: for example, the former effects weighting by more powerful FEC coding. To further weight the coded signal on each route according to the modulation level, each coded signal is subjected to a modulation process.

Specifically, the coded signals, the outputs of the FEC coding units 39a, 39b, are supplied to a first and second signal mapping distributors 23a, 23b, respectively. The first signal mapping distributor 23a converts the coded signal input into mapping data items Ie1, Qe1 to I-axis and Q-axis and supplies them to a first digital modulator 25a. The second signal mapping distributor 23b converts the coded signal input into mapping data items Ie2, Qe2 to I-axis and Q-axis and supplies them to a second digital modulator 25b. The analog signals obtained from the first and second digital modulators 25a, 25b are inputted to an adder 28, which adds them together and outputs the result as a transmission signal.

Here, mapping data items Ie1, Qe1, Ie2, Qe2 are assumed to realize the signal mapping in a modulation constellation according to the values of the modulation amplitude and phase (0° or 180°) with respect to I-axis and Q-axis. Weighting according to modulation level is achieved by using, for example, a 16-QAM modulator as the first digital modulator 25a and a QPSK modulator as the second digital modulator 25b. By doing this, the output data from the second digital modulator 25b has a smaller rate of data transmittable with a single symbol than that from the first digital modulator 25a (for QPSK, 2 bits per symbol, and for 16 QAM, 4 bits per symbol), but the error rate for the modulation symbol on the reception side is about 7 dB better in the carrier-to-noise ratio (hereinafter, abbreviated as C/N).

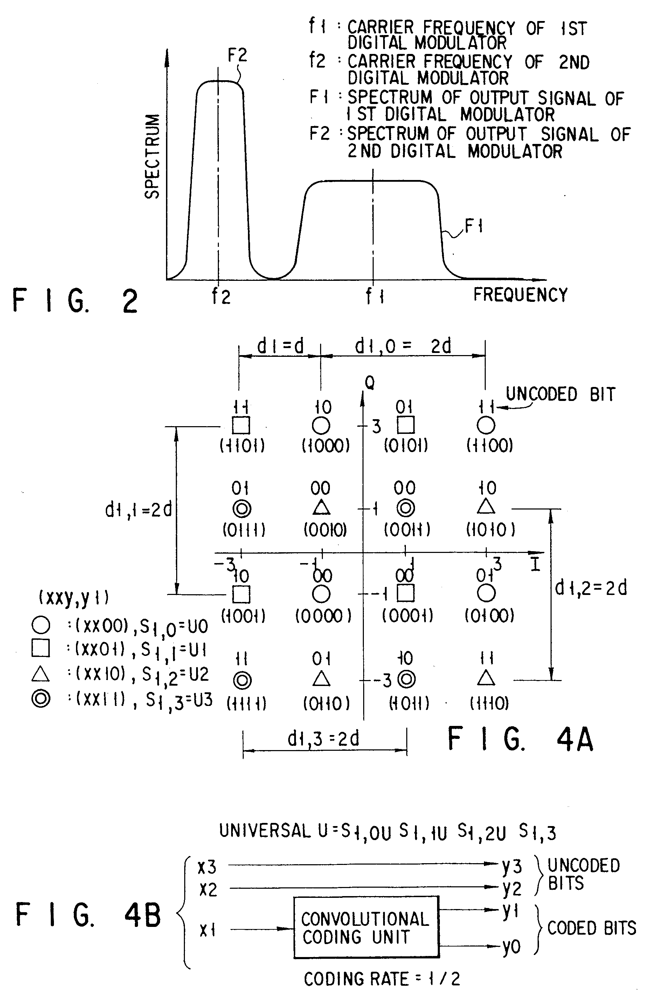

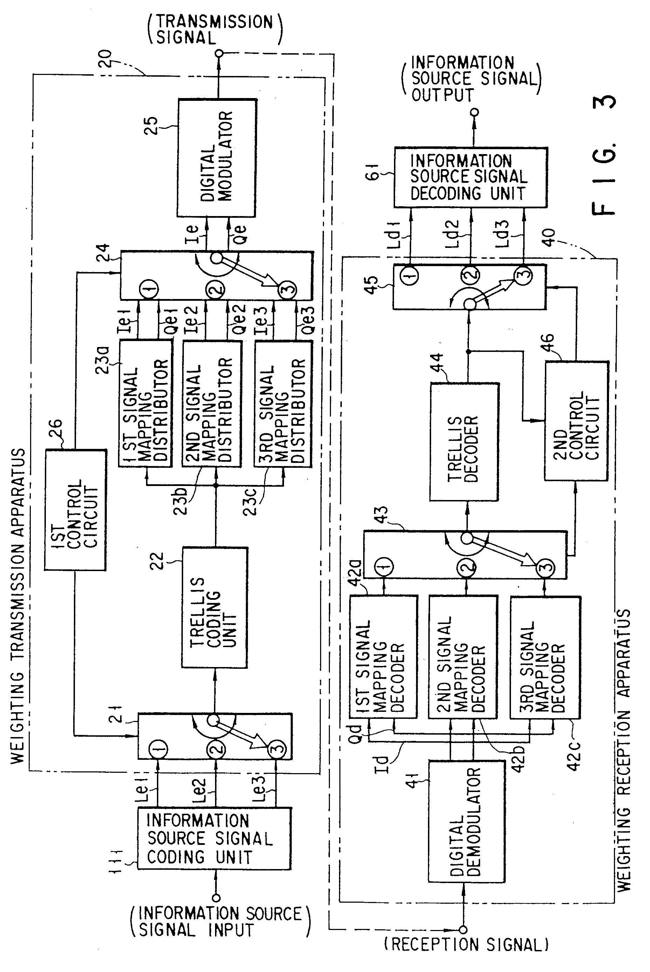

To further weight the characteristic for noise, a weight may be given to the power of modulation carrier as shown in FIG. 2. In FIG. 2, the output spectrum of the second digital modulator 25b has a higher power than that of the first digital modulator 25a, so that the former has a better anti-noise characteristic because of the power difference between the spectra with respect to white noise having the same level of energy.

When such weighting is done, the data rate of information Le2 must be made lower than that of information Le1 in connection with the transmission rate for each level of hierarchy on account of the restrictions on the total transmission power.

The transmission signal (intermediate-frequency signal) shown in FIG. 1 is actually converted into a broadcasting channel signal, which is converted into the original intermediate-frequency signal on the reception side to become the reception signal shown in FIG. 1. The reception signal is demodulated and A/D (analog-to-digital) converted at a first digital demodulator 55a and a second digital demodulator 55b, and are separated into I-axis mapping data items Id1, Id2 and Q-axis mapping data items Qd1, Qd2. These correspond to mapping data items Ie1, Ie2, Qe1, Qe2, respectively.

The mapping data items Id1, Qd1 are restored by a first signal mapping decoder 42a to the same data items on the transmission side. This data undergoes an error correction process at a first FEC decoder 56a, which decodes the data into Ld1 corresponding to information Le1 of the original hierarchic level. The mapping data items Id2, Qd2 are restored by a second signal mapping decoder 42b to the same data items on the transmission side. This data undergoes an error correction process at a second FEC decoder 56b, which decodes the data into Ld2 corresponding to information Le2 of the original hierarchic level. Then, Ld1 and Ld2 are restored by an information source signal decoding unit 61 to the original information source signal.

When data transmission is carried out with the data at each level of hierarchy being weighted as described above, there may be a case where data item Ld1 cannot be restored and data item Ld2 can be restored in a certain range of C/N. In this case, the information source signal decoding unit 61 performs a decoding process using only data item Ld2. Although the quality of the decoded signal deteriorates in terms of resolution due to lack of part of the information, part of the service can be received, so that what is called graceful degradation can be realized.

As described above, the techniques for allocating a weighting to each level of hierarchy in coding transmission include a technique for combining weighting by FEC coding with weighting by modulation level or with weighting by modulation power.

A conventional configuration, however, requires an FEC decoder for each level of hierarchy. If powerful FEC decoders are used, a circuit with as many circuits as several tens of kilo gates is needed for each level of hierarchy, which makes it very difficult to put it to industrial and consumer use.

Accordingly, the object of the present invention is to provide a multilevel weighted transmission method which enables a reduction in the scale of apparatus by increasing the number of circuit shared by the respective levels of hierarchy in realizing a coding apparatus or a decoding apparatus that carries out a process for each level of hierarchy, and an apparatus using the method.

The foregoing object is accomplished by providing a multilevel weighted transmission method where a plurality of hierarchic information source data strings are each subjected to different multilevel weighted coding and modulation and transmitted, and on the reception side, the received signal is subjected to the multilevel weighted demodulation and decoding corresponding to the transmission side to produce the original hierarchic information source data strings, wherein

a trellis-coded modulation scheme is used in coding and of the modulation symbols constituting a constellation for the modulation, m subsets defined in the trellis-coded modulation scheme are determined to be $u_0, u_1, ..., u_{m-1}$;

the universal set U of the modulation symbols is determined to be $U = u_0 \cup u_1 \cup ... \cup u_{m-1}$;

first subsets in the universal set U are determined to be $S_1, S_2, ..., S_n$;

when each of the subsets in the trellis-coded modulation scheme is divided into n second subsets $S_{1,i}, S_{2,i}, ..., S_{n,i}$ (i = 0, 1, ..., m-1), the following expressions are met:

$$u_0 \supseteq S_{1,0}, \quad u_0 \supset S_{2,0}, \quad ..., \quad u_0 \supset S_{n,0}$$
$$u_0 \supseteq S_{1,1}, \quad u_1 \supset S_{2,1}, \quad ..., \quad u_1 \supset S_{n,1}$$
$$...$$
$$u_{m-1} \supseteq S_{1,m-1}, \quad u_{m-1} \supset S_{2,m-1}, \quad ..., \quad u_{m-1} \supset S_{n,m-1};$$

the Euclidean distances d1,i, d2,i, ..., dn,i (i = 0, 1, ..., m-1) between the modulation symbols contained in the second subsets $S_{1,i}, S_{2,i}, ..., S_{n,i}$ are determined to be d1,i < d2,i < ... < dn,i;

the first subset $S_1, S_2, ..., S_n$ are determined to be:

$$S_1 = S_{1,0} \cup S_{1,1} \cup ... \cup S_{1,m-1}$$
$$S_2 = S_{2,0} \cup S_{2,1} \cup ... \cup S_{2,m-1}$$
$$...$$
$$S_n = S_{n,0} \cup S_{n,1} \cup ... \cup S_{n,m-1};$$

the minimum Euclidean distances d1, d2, ..., dn between the modulation symbols contained in the first subsets $S_1$, $S_2$, ..., $S_n$ are determined to be d1 $\leq$ d2 $\leq$ ... $\leq$ dn; and

when $S_1$ to $S_n$ are allocated to the individual hierarchic levels of the transmission channel in the multilevel weighted transmission and the $S_1$ to $S_n$ are time-division multiplexed at a predetermined constant ratio and transmitted, the order of time-division multiplexing the hierarchic levels of the transmission channel is determined to be ascending order of the quality of transmission error characteristic.

Specifically, n hierarchic information source data strings are subjected to n types of multilevel weighted coding and modulation and transmitted. On the reception side, the original n hierarchic information source data strings are decoded by subjecting the received signal to the corresponding n types of multilevel weighted demodulation and decoding. At this time, when the multilevel weighted coding and modulation and multilevel weighted demodulation and decoding contain digital modulation and demodulation [modulation and demodulation by the PSK (Phase Shift Keying), QAM (Quadrature Amplitude Modulation), or QPSK (Quadrature Phase Shift Keying) scheme], the individual hierarchic levels of the transmission channel are expressed as L1, L2, ..., Ln, the universal set of the modulation symbols constituting a constellation of the digital modulation is expressed as U, and U is divided into n first subsets $S_1$, $S_2$, ... $S_n$ by the above dividing technique. Here, the first subsets $S_1$, $S_2$, ..., $S_n$ are allocated to the hierarchic levels L1, L2, ..., Ln of the transmission channel, the transmission route of each of the hierarchic levels L1, L2, ..., Ln of the transmission channel is time-division multiplexed at a predetermined multiplexing ratio and subjected to trellis-coded modulation, and the resulting signal is transmitted. On the reception side, when the information on the hierarchic levels L1, L2, ..., Ln of the transmission channel in the received signal is subjected to a trellis decoding process in time division at the multiplexing ratio, the order of time-division multiplexing the hierarchic levels L1, L2, ..., Ln of the transmission channel is determined to be ascending order of the quality of transmission error characteristic (i.e., in this order: hierarchic levels L1, L2, ..., Ln).

A transmission apparatus of the present invention is a multilevel weighted transmission apparatus which subjects a plurality of hierarchic information source data strings to different multilevel weighted coding and modulation and transmits the resulting strings, and which is characterized by comprising:

a multiplexer which time-division multiplexes the plurality of information source data strings on the basis of a multiplexing ratio;

a trellis coding unit which subjects the output of the multiplexer to trellis coding;

a plurality of signal mapping distributors which, when the universal set of modulation symbols constituting a constellation of the modulation is divided into a plurality of subsets, are provided for each of the subsets, and outputs transmission signal mapping data specifying the modulation symbols contained in each of the subsets; and

control means which determines the order of time-division multiplexing the hierarchic levels of the transmission channel to be ascending order of the quality of transmission error characteristic.

Furthermore, a reception apparatus of the present invention is a multilevel weighted reception apparatus which receives the transmitted data obtained by subjecting a plurality of hierarchic information source data strings to different multilevel weighted coding and modulation and time-division multiplexing them at a specific multiplexing ratio, and then subjects the received signal to the corresponding multilevel weighted demodulation and decoding to obtain the original hierarchic information source data strings, and which is characterized by comprising:

a plurality of signal mapping decoders which, when the demodulated signals are inputted and the universal set of the modulation symbols constituting a constellation of the modulation is divided into a plurality of subsets, output the decision data corresponding to the modulation symbols contained in each of the subsets;

a multiplexer which receives the decision data outputted from the signal mapping decoders, time-division multiplexes the data on the basis of a specific multiplexing ratio, outputs the multiplexed signal;

a trellis decoder which subjects the output of the multiplexer to trellis decoding;

a demultiplexer which separates the output of the trellis decoder into a plurality of hierarchic levels of the transmission channel on the basis of the multiplexing ratio; and

control means which determines the order of decoding the data strings time-division multiplexed at the hierarchic levels to be ascending order of the quality of transmission error characteristic.

This invention ca be more fully understood from the following detailed description when taken in conjunction with the accompanying drawings, in which:

FIG. 1 is a block diagram of a transmission channel coding/decoding apparatus with a multilevel weighting function;

FIG. 2 shows an output spectrum in the case of weighting the power of modulation carrier;

FIG. 3 is a schematic block diagram of a first embodiment of a multilevel weighted transmission apparatus and reception apparatus according to the present invention;

FIG. 4A shows a signal mapping in the coding modulation scheme when 16 QAM is used for digital modulation in the first embodiment;

FIG. 4B shows a configuration of a coding unit;

FIGS. 5A, 5B, and 5C show the signal mapping at each level of hierarchy in the first embodiment, respectively;

FIG. 6A shows the symbol mapping with the Hamming distance between adjacent symbols being made as small as possible, and FIG. 6B shows a symbol mapping with the 180° phase invariant;

FIG. 7 is the transmission error characteristic for each level of hierarchy only in the first embodiment;

FIG. 8 is a schematic block diagram of another embodiment of a multilevel weighted transmission apparatus according to the present invention;

FIG. 9 is a schematic block diagram of still another embodiment of a multilevel weighted transmission apparatus according to the present invention;

FIG. 10 shows the contents of the mapping in the ROM in the embodiment of FIG. 9;

FIG. 11 is a schematic block diagram of another embodiment of a multilevel weighted transmission apparatus according to the present invention;

FIG. 12A is a timing chart to help explain error propagation in multiplexing in a case where operation moves from a hierarchic level with a good error characteristic to that with a bad error characteristic;

FIG. 12B is a timing chart to help explain how to prevent errors from propagating by inserting dummy blocks associated with the present invention;

FIG. 13 is a timing chart for a time-division multiplex signal containing dummy blocks in an embodiment of the present invention;

FIG. 14 is a schematic block diagram of a multilevel weighted transmission apparatus in the case where trellis coding contains convolutional codes and the case where the frame information is added to the data string, in connection with the present invention;

FIG. 15 is a schematic block diagram of a reception apparatus corresponding to the embodiment of FIG. 14;

FIGS. 16A and 16B are drawings to help explain the area decision at the trellis decoder in an embodiment of the present invention;

FIG. 17 is a block diagram of a reception apparatus with a detailed mapping of the optimized trellis decoder, in an embodiment of the present invention;

FIG. 18 is the BER characteristic diagram for each level of hierarchy obtained by computer simulation;

FIG. 19 is the BER characteristic diagram for each level of hierarchy obtained by computer simulation in a case where multilevel weighted transmission is carried out without a dummy block;

FIG. 20 is the BER characteristic diagram for each level of hierarchy obtained by computer simulation in a case where multilevel weighted transmission is carried out with dummy block size 8;

FIG. 21 is the BER characteristic diagram for each level of hierarchy obtained by computer simulation in a case where multilevel weighted transmission is carried out with dummy block size 32;

FIG. 22 is the BER characteristic diagram for each level of hierarchy obtained by computer simulation in a case where multilevel weighted transmission is carried out with dummy block sizes ranging from 0 to 32;

FIG. 23 shows a signal mapping at hierarchic level L2 in an embodiment of the present invention;

FIG. 24 is a block diagram of still another embodiment of the multilevel weighted transmission apparatus;

FIG. 25 is the BER characteristic diagram for each level of hierarchy obtained by computer simulation;

FIG. 26 shows a signal mapping at hierarchic level L2 in an embodiment of the present invention;

FIG. 27 is a block diagram of a reception apparatus with a detailed mapping of a trellis decoder in a case where the frame information and the multiplexing ratio information are added to the data string, in connection with the present invention;

FIG. 28 is a schematic block diagram of another embodiment of a multilevel weighted transmission apparatus and reception apparatus according to the present invention;

FIG. 29 is a schematic block diagram of still another embodiment of a multilevel weighted bransmission apparatus and reception apparatus according to the present invention;

FIG. 30 is a schematic block diagram of a multilevel weighted transmission apparatus in a case where the frame information is added in using concatenated coding as FEC coding, in connection with still another embodiment of the present invention;

FIG. 31 is a schematic block diagram of a reception apparatus corresponding to the transmission apparatus of FIG. 30;

FIG. 32 is a schematic block diagram of still another embodiment of a multilevel weighted transmission apparatus and reception apparatus according to the present invention;

FIG. 33A is a timing chart of time division timing for the data string at each level of hierarchy in an embodiment of the present invention;

FIG. 33B shows a spectrum of hierarchic levels L1, L2, L3;

FIG. 34 is a schematic block diagram of still another embodiment of a multilevel weighted transmission apparatus and reception apparatus according to the present invention;

FIG. 35 is a block diagram of a convolutional coding unit (k = 7) according to an embodiment of the present invention;

FIG. 36 is a timing chart of time division timing for the data string at each level of hierarchy in an embodiment of the present invention;

FIG. 37 is a schematic block diagram of still another embodiment of a multilevel weighted transmission apparatus and reception apparatus according to the present invention;

FIG. 38 is the BER characteristic diagram for each level of hierarchy obtained by computer simulation in a case where multilevel weighted transmission is carried out;

FIG. 39 is the BER characteristic diagram for each level of hierarchy obtained by computer simulation in a case where multilevel weighted transmission and multiplex transmission are carried out without a dummy block;

FIG. 40 is the BER characteristic diagram for each level of hierarchy obtained by computer simulation in a case where multilevel weighted transmission and multiplex transmission in ascending order of the error characteristic for the individual levels of hierarchy are carried out without a dummy block; and

FIG. 41 is the BER characteristic diagram for each level of hierarchy obtained by computer simulation in a case where multilevel weighted transmission and multiplex transmission in ascending order of the error characteristic for the individual levels of hierarchy are carried out with dummy blocks.

Hereinafter, referring to the accompanying drawings, an embodiment of the present invention will be explained.

FIG. 3 is a schematic block diagram of a multilevel weighted transmission apparatus and reception apparatus according to the present invention. In FIG. 3 and those showing the embodiments explained later, almost the same or equivalent blocks are indicated by the same reference symbols and repeated explanation will be avoided.

First, explanation of the transmission side will be given.

An information source signal input is subjected to processes, including compression and partition into levels of hierarchy, at an information source signal coding unit 11, which separates the input into Le3, Le2, Le1 in descending order of importance of information, and outputs them (in this example, the number of hierarchic levels is 3). The important information is the information set according to the contents of data to be transmitted. For example, in the case of video data, it is separated by frequency. These signals are time-division multiplexed at a predetermined rate at a first multiplexer 21 in a multilevel weighted transmission apparatus 20 and are inputted to a trellis coding unit 22.

The signal to which a redundant bit for error correction has been added by trellis coding is inputted to a first signal mapping distributor 23a, a second signal mapping distributor 23b, and a third signal mapping distributor 23c. The trellis coding unit 22 adds a dummy block to a data string, which will be explained later.

If the universal set of modulation symbols dealt with by a digital modulator 25 is U, it is divided into first subsets $S_1$, $S_2$, $S_3$, which meet the expression: $U \geq S_1 > S_2 > S_3$. Then, the first signal mapping distributor 23a, receiving the transmission data, produces mapping data items Ie1, Qe1 to I-axis and Q-axis, which specify only modulation symbols contained in subset $S_1$, and output them. The second signal mapping distributor 23b, receiving the transmission data, produces mapping data items Ie2, Qe2 to I-axis and Q-axis, which specify only modulation symbols contained in subset $S_2$, and output them. The third signal mapping distributor 23c, receiving the transmission data, produces mapping data items Ie3, Qe3 to I-axis and Q-axis, which specify only modulation symbols contained in subset $S_3$, and output them. The first minimum Euclidean distances d1, d2, d3 for the respective subsets meet the equation: d1 < d2 < d3

A second multiplexer 24 multiplexes these mapping data items at a predetermined multiplexing rate and outputs the resulting signals Ie and Qe, which are modulated at the digital modulator 25, which then transmits the modulated signal.

Explanation of the reception side will be given. On the reception side, a digital demodulator 41 in a multilevel weighted reception apparatus 40 demodulates the received signal into mapping data items Id, Qd corresponding to Ie, Qe and outputs these data items. The data items are inputted to a first signal mapping decoder 42a, a second signal mapping decoder 42b, and a third signal mapping decoder 42c corresponding respectively to the first, second, and third signal mapping distributors 23a, 23b, 23c. The individual decoders output mapping decoded data items corresponding to the subsets $S_1$, $S_2$, $S_3$ of modulation symbols.

A third multiplexer 43, to which the mapping decoded data items are inputted, performs a time-division multiplexing process at the multiplexing ratio to produce a signal for one route. The produced signal is inputted to a trellis decoder 44, which decodes it. The decoded output contains a data string into which Ld1, Ld2, Ld3 corresponding to Le1, Le2, Le3 are time-division multiplexed. The data string is inputted to a demultiplexer 45, which separates it into Ld1, Ld2, Ld3. These separated outputs Ld1, Ld2, Ld3 are reproduced by an information source signal decoding unit 61 into the original information source signal, which is then outputted. The trellis decoder 44 decodes a dummy block as well.

The above embodiment will be explained in more detail with reference to FIGS. 4A and 4B.

Explanation will be given on the assumption that there is no error in the sequence of time-division multiplexing and the insertion of dummy blocks prevents errors from propagating.

FIG. 4A shows a signal mapping in the trellis-coded modulation scheme in the case where 16-QAM is used for digital modulation. This mapping is made for 16-QAM on the basis of reference [2]: A. J. Viterbi, "A Pragmatic Approach to Trellis-Coded Modulation," IEEE Communication Magazine, vol. 27, 1989.

The signal mapping is determined as follows.

As shown in FIG. 4B, the coding rate r of the convolutional coding unit is r = 1/2 and two bits (y1 y0) are used as coded bits. Namely, the convolutional coding unit has one bit on the input and two bits on the output. There are four subsets ($u_0$, $u_1$, $u_2$, $u_3$) specified by these pieces of coding information. Two bits are used as uncoded bits.

Specifically,

a set of modulation symbols for (y1 y0) = (0 0) is determined to he $u_0$ and represented by ⌈○⌋;

a set of modulation symbols for (y1 y0) = (0 1) is determined to be $u_1$ and represented by ⌈□⌋;

a set of modulation symbols for (y1 y0) = (1 0) is determined to be $u_2$ and represented by ⌈△⌋;

a set of modulation symbols for (y1 y0) = (1 1) is determined to be $u_3$ and represented by ⌈◎⌋;

If the universal set of modulation symbols for 16-QAM is U, U will be $U = u_0 \cup u_1 \cup u_2 \cup u_3$.

The mapping of the individual subset in coding modulation is based on the principle of set partitioning of Ungerboeck. The mapping is made so that the distance between modulation symbols in each subset may be maximized. Namely, the convolutional coding unit of FIG. 4B is a unit that can perform powerful error correction or has a sufficiently large distance between code sets represented by (y1 y0). Then, in a state where the coded bits are decoded properly (where C/N is higher than a specific value), the transmission error characteristic in decoding depends roughly on the distance between modulation symbols in each of the subsets. The greater the distance between modulation symbols, the smaller the transmission error rate, whereas the smaller the distance between modulation symbols, the greater the transmission error rate.

In FIGS. 4A and 4B, if the minimum Euclidean distance between modulation symbols of uncoding 16-QAM is d, the minimum Euclidean distance between modulation symbols in the subset will be 2d. Therefore, as compared with uncoding 16-QAM, the symbol error rate in coding modulation can be expected to improve nearly 6 dB in C/N.

It should be noted that four bits of information can be transmitted using a single modulation symbol of uncoding 16-QAM, whereas only three bits of information per modulation symbol (x3 x2 x1) can be transmitted in the coding modulation scheme shown in FIGS. 4A and 4B. The value 6 dB in C/N, the degree of improvement in the transmission error characteristic, involves the sacrifice of the transmission rate of the information, so that the definition differs from that of an ordinarily used coding gain.

Since the multilevel weighted transmission discussed in the present invention, however, involves the sacrifice of the transmission rate at the information section at each level of hierarchy, it is undesirable to proceed with the discussion using a coding gain. Therefore, in the discussion below, attention will be paid to the degree of improvement in the transmission error (the symbol error rate or bit error rate) in C/N.

The mapping of the individual subsets is as described above. The bits are allocated as follows.

The reception apparatus, which receives and decodes the information subjected to coding modulation, performs a decoding operation on the modulated symbol (the representative point of each subset) closest to the received symbol subjected to soft decision.

To achieve the decoding operation, the coded bits are mapped in Gray codes for the four modulation symbols, a set of the representative points of the subsets ({◎, △, ○, □}, for example, {(0011), (1010), (1100), (0101)} in FIG. 4A). The Hamming distance between adjacent modulation symbols for (y1 y0) is "1." Furthermore, for the modulation symbols in each subset, the uncoded bits are mapped in Gray codes. Namely, for example, for (y3 y2) of the four modulation symbols in ○, the Hamming distance of adjacent modulation symbols is "1." In reference [2] noted earlier, a similar signal mapping is made using PSK modulation.

In the case of the universal set U of modulation symbols in FIG. 4A, the first subset $S_1$ allocated to hierarchic level L1 is determined to be set U. The second subsets $S_{1,0}$, $S_{1,1}$, $S_{1,2}$, $S_{1,3}$ in each subset are determined to be as follows:

$$S_{1,0} = u_0$$

$$S_{1,1} = u_1$$

$$S_{1,2} = u_2$$

$$S_{1,3} = u_3$$

where $S_1 = S_{1,0} \cup S_{1,1} \cup S_{1,2} \cup S_{1,3}$

A first minimum Euclidean distance d1 between modulation symbols contained the first subset $S_1$ is equal to d. A second Euclidean distance d1,i (i = 0, 1, 2, 3) in each S1,i (i = 0, 1, 2, 3) is equal to 2d.

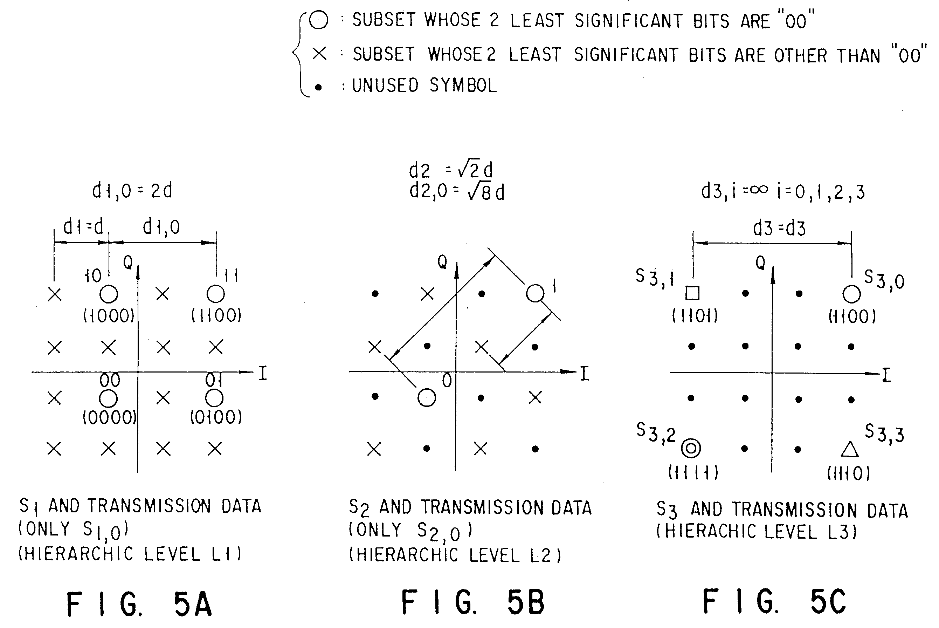

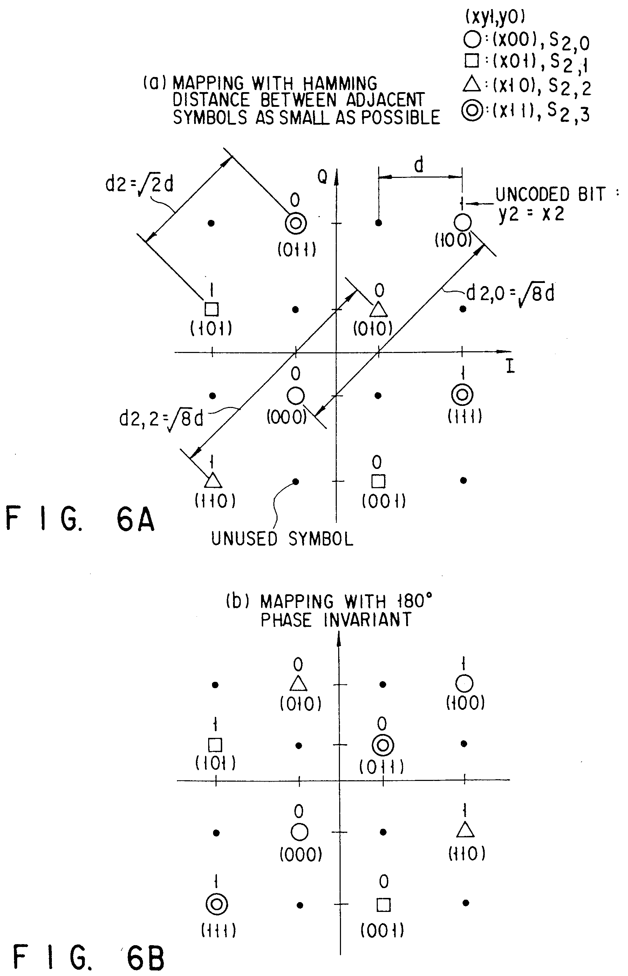

FIGS. 5A, 5B, and 5C shows the signal mapping in the first subsets $S_1$, $S_2$, $S_3$ in the above embodiment. FIGS. 5A and 5B show only the modulation symbols for ○, (y1 y0) = (0 0). The signal mapping of all the symbols in the first subset $S_1$ of FIG. 5A is what has been explained in FIG. 4A. The signal mapping of all the symbols in the first subset $S_2$ of FIG. 5B is shown in FIG. 6A. The first subset $S_2$ uses only eight modulation symbols, half of set U ($U \supset S_2$). That is, in the first subset $S_1$, modulation symbols marked with ⌈ · ⌋are not used. Furthermore, in the first subset $S_2$, its second subsets S2,0, S2,1, S2,2, S2,3 are determined to be modulation symbols ○, □, △, ◎, respectively, as shown in FIGS.

6A and 6B. Since for the number of transmission bits, each modulation symbol has three bits (y2 y1 y0), the number of information bits is 2 bits (x2 x1). In coding, x1 is expanded to two bits (y1 y0), giving y2 = x2·

A second minimum Euclidean distance d2,i (i = 0, 1, 2, 3) between modulation symbols contained in each second subset $S_{2,i}$ (i = 0, 1, 2, 3) is √8d, √2 times that of d1,i (i = 0, 1, 2, 3). Therefore, the difference in the error characteristic between hierarchic levels L1 and L2 indicates an improvement of 3 dB in the symbol error rate. Furthermore, a first minimum Euclidean distance is d2 = √2d = √2d1 .

For the first subset $S_3$, only the symbols at the four corners of 16-QAM are used as shown in FIG. 5C. The number of elements in its second subsets $S_{3,i}$ (i = 0, 1, 2, 3) is "1." The second minimum Euclidean distance for each subset is defined as ∞ (d3,i = ∞ , i = 0, 1, 2, 3).

That is, if the number of coded bits is k, the number m of subsets in the coding modulation scheme will be m = $2^k$. Furthermore, if the number of modulation symbols contained in each of the second subsets is one or more and the number of modulation symbols contained in each of $S_{n,i}$ (i = 0, 1, ..., m-1) is one, then the corresponding second minimum Euclidean distance dn,i (i = 0, 1, ..., m-1) is defined as infinite.

Furthermore, the first minimum Euclidean distance is d3 = 3d = 3d1  and the constellation of the first subset $S_3$ is the constellation of QPSK, so that trellis-coded modulation is carried out using powerful convolutional codes with a constraint length of 7 in coding, achieving an improvement of 8 to 9 dB in uncoding QPSK in the error characteristic of hierarchic level L3. The constraint length means the number of information inputs (the distance between pieces of information) required to obtain the coded output of the input information.

Then, when

$$d2,i = (\sqrt{2}) \times d1,i$$

$$d3,i = \infty \ (i = 0, 1, 2, 3)$$

$$d3 = 3di, d2 = (\sqrt{2}) \times d1$$

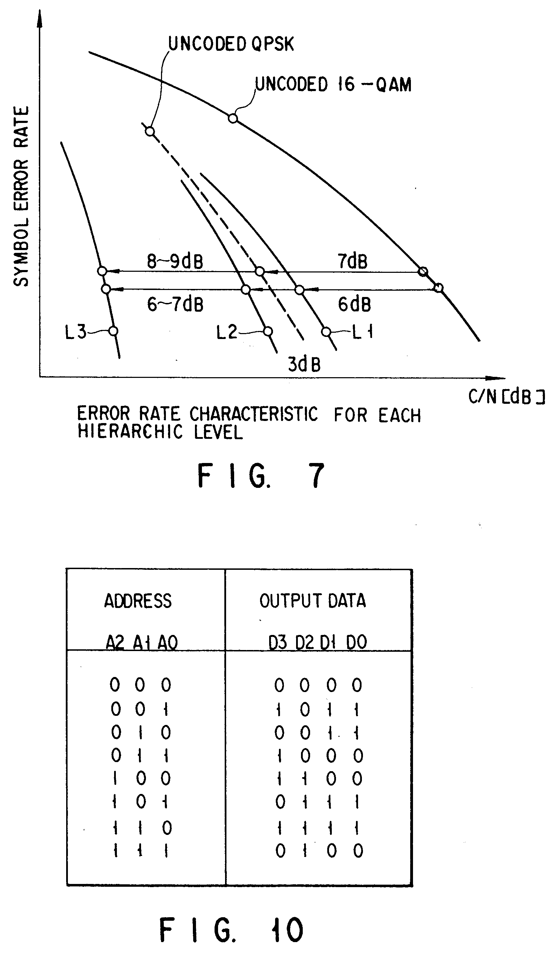

the error characteristic for each level of hierarchy is shown in FIG. 7.

The degree of improvement in the transmission error characteristic at hierarchic level L3 as compared with hierarchic level 1 reaches up to 15 to 16 dB in C/N when there is no decoding error propagation.

A second embodiment of the present invention will be explained.

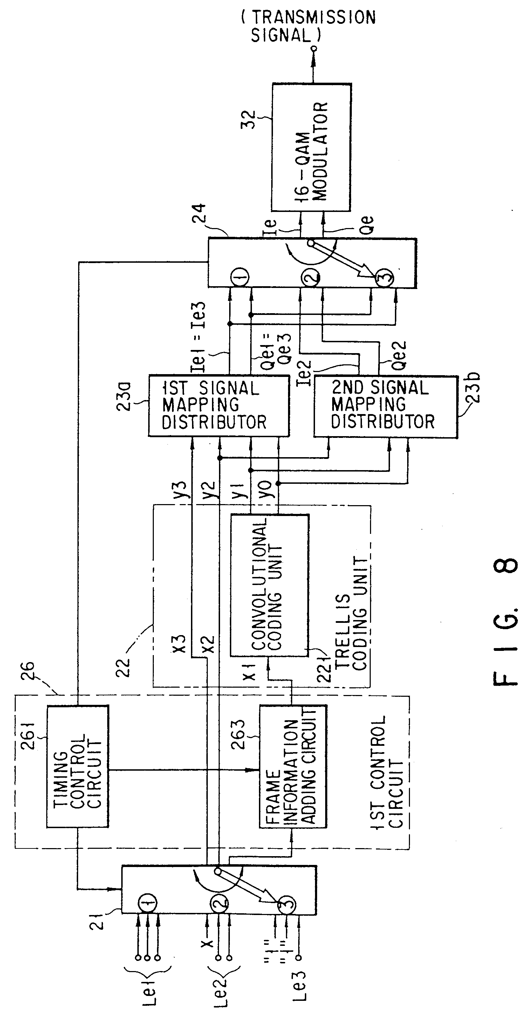

FIG. 8 shows another embodiment of the multilevel weighted transmission apparatus of the first embodiment shown in FIG. 3.

In FIG. 8, the ratio of transmission rate per symbol at hierarchic levels L1, L2, L3 of the transmission channel is 3:2:1. The number of bits of each of data strings Le1, Le2, Le3 from the information source is 3, 2, and 1, respectively. A first multiplexer 21 time-division multiplexes these data strings Le1, Le2, Le3 at a specified ratio, and outputs the result in the form of a 3-bit data string. x3 is inputted as y3 to a first signal mapping distributor 23a. x2 is inputted as y2 to the first and second signal mapping distributors 23a, 23b. Only the least-significant one x1 in the there bits (x3 x2 x1) is inputted via a frame information adding circuit 263 to a trellis coding unit 22 containing a convolutional coding unit 221, and is expanded from one bit (x1) to two bits (y1 y0). This provides a transmission code (y3 y2 y1 y0) added with a redundancy.

The first signal mapping distributor 23a outputs mapping data items Ie1, Qe1 based on the modulation symbols in the first subset $S_1$. The two least significant bits (y1 y0) in the transmission bits allocated to the modulation symbols at the four corners of the first subset $S_1$ agree with (y1 y0) allocated to the four modulation symbols in the first subset $S_3$ of FIG. 5C. When y3 = 1 and y2 = 1 in the first subset $S_3$, the transmission bits allocated to the modulation symbols at the four corners of the first subset $S_1$ all agree with those of the first subset 3.

With the timing that L3e is transmitted, giving x3 = x2 = 1  enables the output of the first signal mapping distributor 23a to be used. Since with the timing that Le2 is transmitted, the signal mapping of FIG. 6A is used, the second signal mapping distributor 23b is needed. The transmission signal uses only three bits (y2 y1 y0) (the input of x3 is not necessary).

The outputs of the first mapping distributor 23a and second mapping distributor 23b are converted by a second multiplexer 24 into the Ie, Qe time-division multiplexed at the ratio in the above time-division multiplexing. Then, a 16-QAM modulator 32 produces a transmission signal. The timing control at that time is executed by a first control circuit 26.

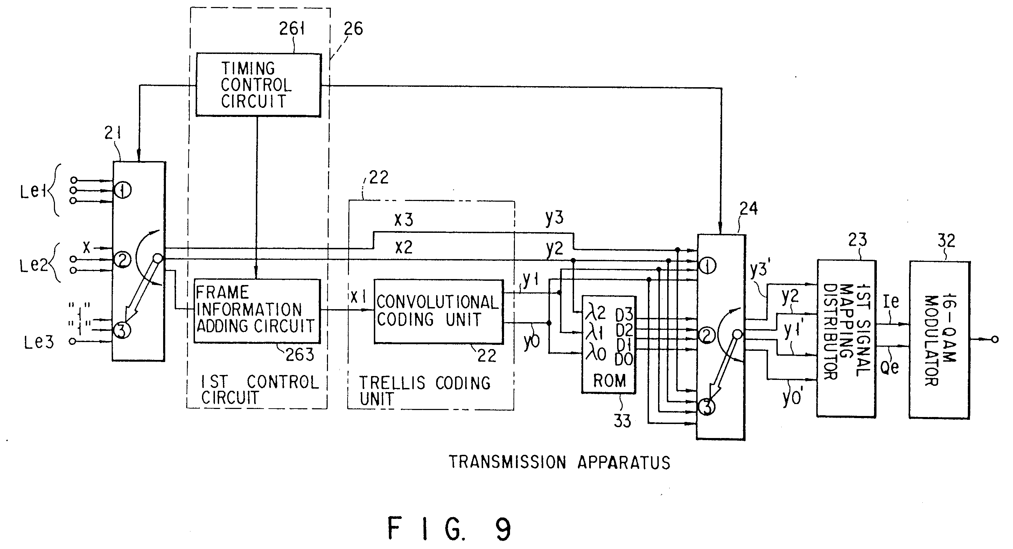

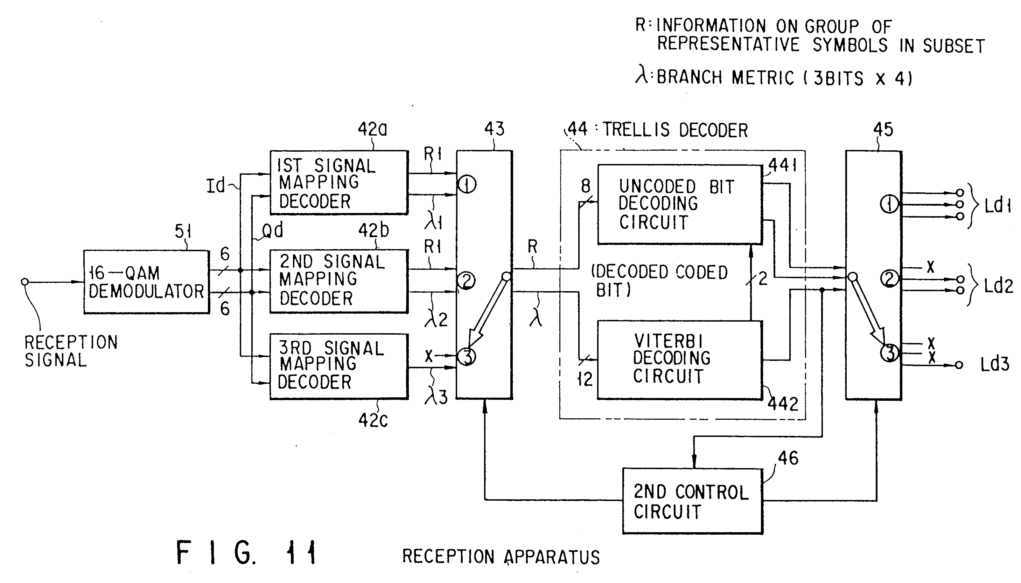

A third embodiment of the present invention will be explained with reference to FIGS. 9 and 10.

Unlike the embodiment of FIG. 8, the embodiment of FIG. 9 does not have the second signal distributor 23b.

Since the first subset $S_2$ is $S_1 \supset S_2$ in terms of the mapping of modulation symbols, the signal mapping distributor 23 can be used equally in coding data strings Le1, Le2, Le3 by converting the mapping of transmission codes at a ROM 33. The relationship between the input and output of the ROM 33 is shown in FIG. 10. For example, when the mapping of FIG. 6A is used, the modulation symbols used for mapping (y2 y1 y0) = (0 0 1) in the first subset $S_2$ corresponds to the modulation symbols used for mapping (y3 y2 y1 y0) = (1 0 1 1) in the first subset $S_1$. The second multiplexer 24 time-division multiplexes (y3 y2 y1 y0) with the 4-bit signal into which (y2 y1 y0) has been expanded at the ROM 33 and produces (y'3 y'2 y'1 y'0), which is inputted to the first signal mapping distributor 23, which produces Ie and Qe.

The ROM 33, the second multiplexer 24, and the first signal mapping distributor 23 can be constructed using a single ROM and a control circuit that controls time-division multiplexing. In this case, (y3 y2 y1 y0) is used as the address input and the timing control signal outputted from the control circuit to a single ROM 33, then the ROM outputs Ie and Qe. This applies to the mapping of FIG. 6B with a phase of 180° being uncertain. When the 180°-phase uncertainty is used, differential coding is effected before convolutional coding.

A fourth embodiment of the present invention will be explained.

FIG. 11 shows a multilevel weighted reception apparatus corresponding to the multilevel weighted transmission apparatus of the second or third embodiment.

In this specification, for the sake of explanation, it is assumed that the trellis decoder does not contain a BMU (blanch metric computing means), area deciding means, or representative symbol sensing means. These means are assumed to be contained in the signal mapping decoding means.

Furthermore, a dummy block added to the rear end of the portion corresponding to a level of hierarchy with a good transmission error characteristic is also subjected to the trellis decoding process.

The received signal is demodulated by a 16-QAM decoder 51, which produces signals Id and Qd corresponding to component I and component Q in the received symbol position. Viterbi decoding is used to decode the convolutionally coded bit x1. To achieve this, a soft decision is made. To make a hard decision of the modulation symbols shown in FIG. 4A, for example, three bits per axis (-3: 100, -1: 111, +1: 001, +3: 011) are sufficient. In a soft decision, how closer to which symbol must be expressed as well. For example, this is expressed by six bits on each axis as follows: (-3: 101000, -1: 111000, +1: 001000, +3: 010000).

The first signal mapping decoder 42a and the second signal mapping decoder 42b, which contain subset representative symbol sensing circuits and BMUs, determine the representative symbols of the individual subsets (in this example, the four symbols closest to the received signal) through a soft decision on the basis of Id and Qd. They output two most significant bits for each of the four symbols, a total of eight bits as R1 and one bit for the respective symbols, a total of four bits as R2. Since the first subset $S_3$ is only one for each symbol, a hard decision is not necessary.

Furthermore, the Euclidean distance between the representative symbols of the individual subsets subjected to the hard decision is squared and branch metrics $\lambda1$, $\lambda2$, $\lambda3$ for four symbols are outputted. The branch metrics are expressed by a suitable number of bits. For example, because one branch metric is expressed by three bits, each of $\lambda1$, $\lambda2$, and $\lambda3$ contains 12 bits.

For branch metrics, the square of the Euclidean distance between the receive symbol and the representative symbol of each subset is used. Branch metrics may be obtained in such a manner that the received symbol is limited in amplitude and the square of the Euclidean distance between the amplitude-limited data and the representative symbol of each subset is calculated by Euclidean distance computing means and further a nonlinear process and the discarding of most significant bits are effected to produce a branch metric with a reduced number of bits. By doing this, one branch metric can be expressed in three bits.

A third multiplexer 43 time-division multiplexes information R1 and R2 on combinations of representative symbols in the above-described subsets with branch metrics $\lambda1$, $\lambda2$, $\lambda3$ on the basis of information on the ratio of time-division multiplexing, and outputs R and $\lambda$. When Ld1 and Ld2 are decoded from R and $\lambda$, the bits Viterbi-decoded using $\lambda$ is subjected again to the same convolutional coding as that on the transmission side, thereby producing the decoded coded bits (two bits). Receiving these inputs, an uncoded bit decoding circuit 441 determines which decoded symbol the subset corresponds to from a group of representative symbols of the subset specified by the R (R1). The circuit determines the two most significant bits.

Similarly, when Ld2 is decoded, one is selected from a group of representative symbols (four modulation symbols) of the subset specified by R (R2) on the basis of the decoded coded bits, and the one most significant bit is determined. With the timing that Ld3 is decoded, R is not necessary and only the Viterbi decoding circuit 442 decodes only the least-significant bit and outputs Ld3.

Generally, Viterbi decoding contains branch metric computation. In the present embodiment, however, for the sake of convenience, it is assumed that the former does not contain the latter.

Because the decoded data items Ld1, Ld2, Ld3 are time-division multiplexed at the output of the trellis decoder 44, the demultiplexer 45 separates the output into the original Ld1, Ld2, Ld3.

It is obvious that in the configuration of FIG. 11, the first, second, and third signal mapping decoders 42a, 42b, 42c and the third multiplexer 43 can be constructed of a single ROM and a control circuit that controls time-division multiplexing. In this case, Id and Qd and the output of the control circuit correspond to the input addresses to the ROM. The R and $\lambda$ correspond to the output of the ROM.

A second control circuit 46 senses, for example, frame synchronization and performs control so that trellis decoding may be effected in ascending order of quality of the transmission error characteristic in the frame.

Explanation of the setting of the order in which hierarchic levels are transmitted will be given.

When convolutional coding in the trellis coding is contained, Viterbi decoding needs a plurality of modulation symbols to reproduce one decoded symbol. Because of this, when operation moves from a hierarchic level with a good transmission error characteristic to a hierarchic level with a bad transmission error characteristic, error propagation takes place from the data in the bad hierarchic level to the data in the good hierarchic level as shown in FIG. 12A.

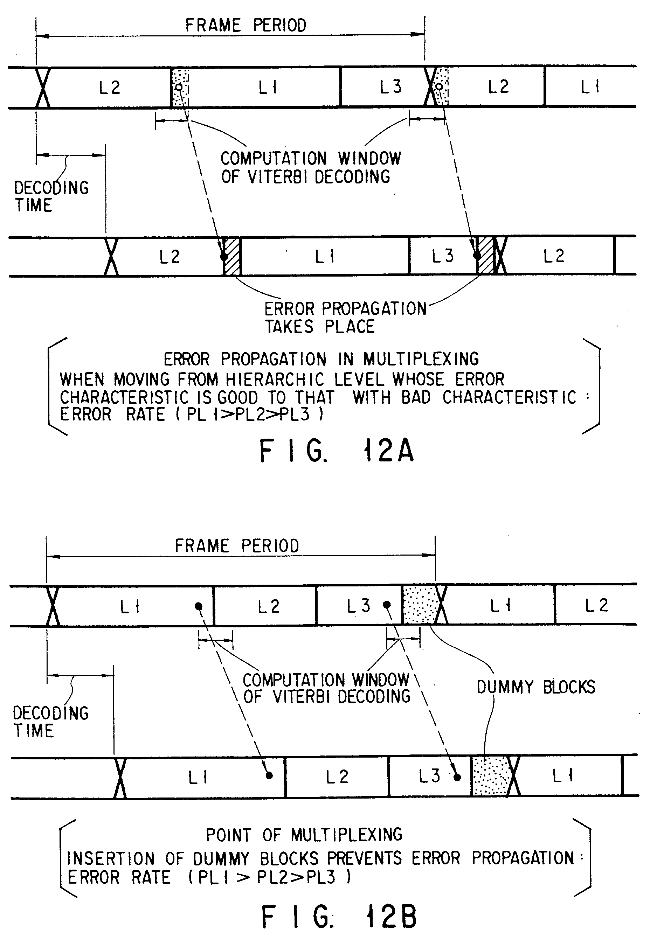

By effecting time-division multiplexing from a hierarchic level with a bad transmission error characteristic to a hierarchic level with a good hierarchic level within one frame as shown in FIG. 12B, the effect of error propagation can be minimized. For example, in the case of hierarchic level L1 → L2 → L3, error propagation occurs only at the boundary of the frame (the rear end of the frame). In this case, even if the error characteristic is bad for several to several tens of symbols in the rear end of the frame, that is, for as many symbols as four to six times the constraint length, specific data items should be multiplexed. For example, as shown in FIG. 12B, the data string for the dummy (dummy block D) or the data string for hierarchic level L1 should be multiplexed. When the data string for hierarchic level L1 is multiplexed, however, it should be noted that the transmission efficiency in that portion is such that only one bit per modulation symbol can be transmitted.

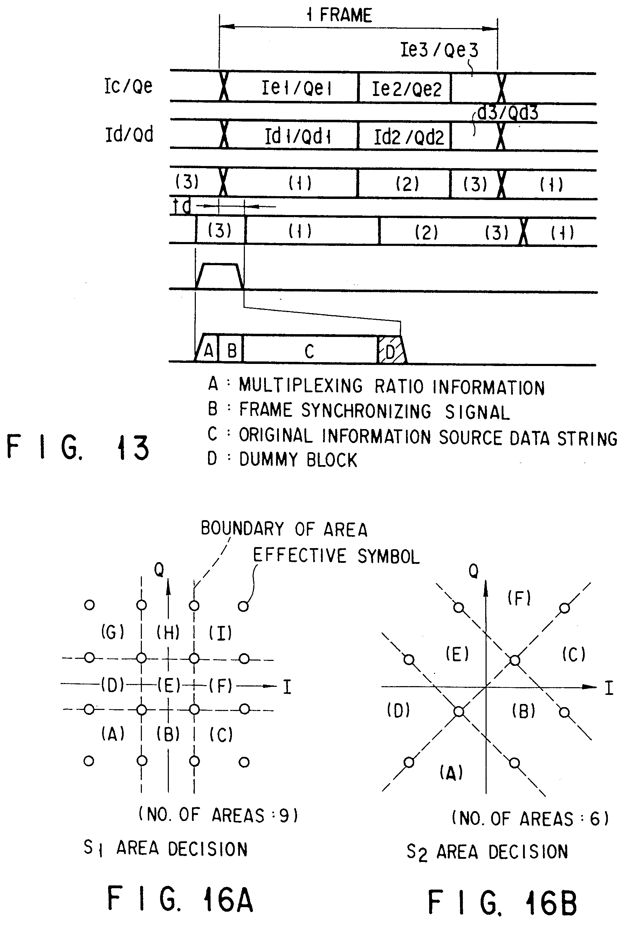

FIG. 13 shows the signals of various sections outputted from the apparatus of FIG. 11 when hierarchic level L1 → L2 → L3 is transmitted as described above. Ie1, Qe1, Ie2, Qe2, Ie3, Qe3 indicate the coded signal on the transmission side, Id1, Qd1, Id2, Qd2, Id3, Qd3 indicate the decoded signals on the reception side, and L1, L2, L3 indicate the signals for the respective hierarchic levels. td is the decoding time. The signal for hierarchic level L3 consists of multiplexing ratio information A, a frame synchronization number B, a data string, and the above-described dummy block D.

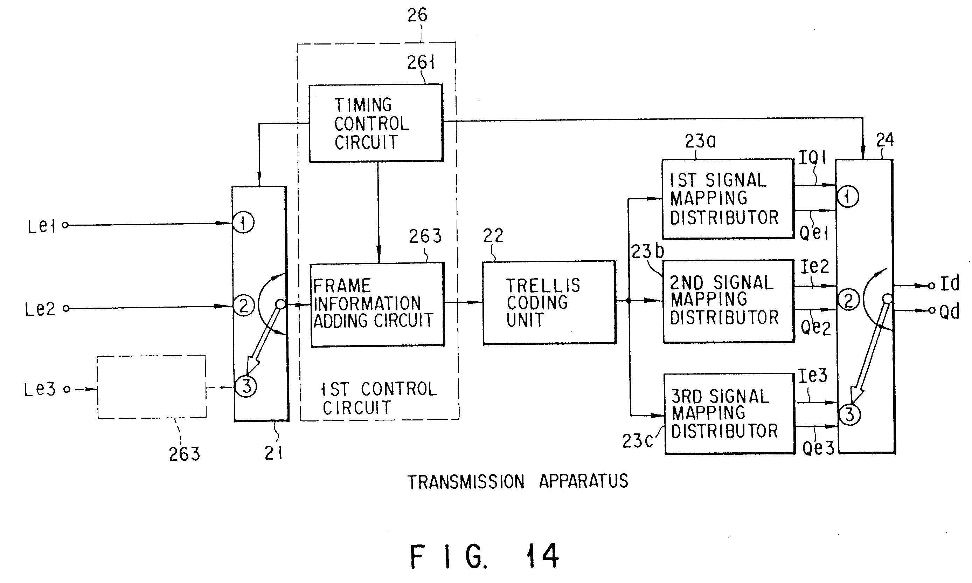

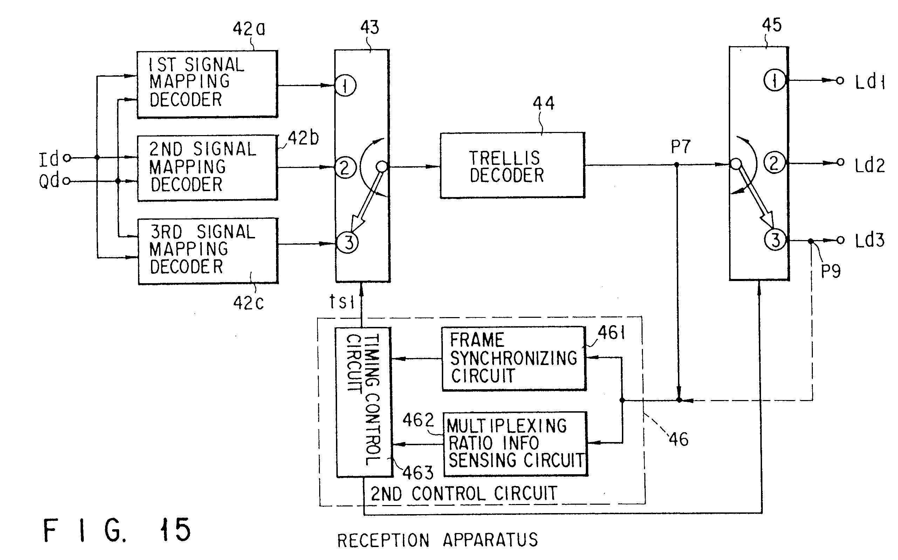

Referring to FIGS. 14 and 15, still another embodiment of the reception apparatus will be described.

The advantage of containing convolutional codes in FEC coding is that Viterbi decoding, which is a decoding method for FEC coding, does not require block synchronization for several tens to several hundreds of symbols. When the trellis-coded modulation scheme is used, FEC decoding can be particularly effected as long as the synchronization for each received modulation symbol, or specifically, the symbol synchronization for reproduction at the digital decoder, has been established. Therefore, the data string after FEC decoding can be used in establishing the frame synchronization, so that frame synchronization can be established reliably.

In the transmission apparatus of FIG. 14, a frame information adding circuit 263 is controlled by a timing control circuit 261 provided in the control circuit 26.

In the frame information adding circuit 263, information on the multiplexing ratio or the frame synchronizing signal, or both are added to the data string (the data string at hierarchic level L3 whose transmission error rate is the lowest, see FIG. 13) before FEC coding. The frame information adding circuit 263 may be added before the first multiplexer 21 as shown by dotted lines.

On the other hand, on the reception side, as shown FIG. 15, the multiplexing ratio information is sensed or the frame synchronization is established, or both actions are performed. Specifically, the data string decoded at the trellis decoder 44 is also supplied to a frame synchronizing circuit 461 and a multiplexing ratio information sensing circuit 462 constituting the second control circuit 46. The frame synchronizing circuit 461 senses the frame synchronizing information, establishes the frame synchronization, and produces a frame synchronizing signal. The frame synchronizing signal and the multiplexing ratio information sensed at the multiplexing ratio information sensing circuit 462 are supplied to a timing control circuit 463. On the basis of the multiplexing ratio information and the frame synchronizing signal, the timing control circuit 463 controls the multiplexer 43 and the demultiplexer 45.

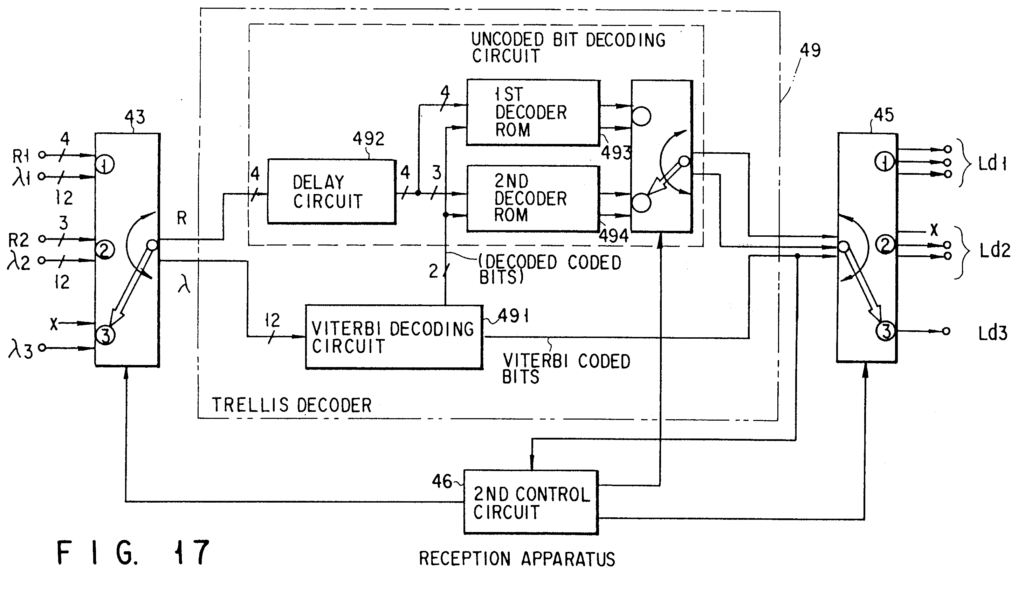

Still another embodiment will be described with reference to FIGS. 16A, 16B, and 17.

FIG. 17 shows the inside of the trellis decoder in the reception apparatus of FIG. 11.

In the embodiment of FIG. 11, the two most significant bits in the information R (= R1) for a group of representative symbols (four modulation symbols) of the subsets in the first subset $S_1$ are picked up to provide 8-bit representation. When the received symbol is decided, however, deciding in which of the nine areas (A), (B), (C), (D), (E), (F), (G), (H), and (I), the received symbol is present, enables information R1 to be expressed in four bits (two bits for I channel and two bits for Q channel). This is because the individual areas (A), (B), (C), (D), (E), (F), (G), (H), and (I) correspond to a group of representative symbols ($\bigcirc$, □, △, ◎) on a one-to-one basis. That is, a group of representative symbols ($\bigcirc$, □, △, ◎) corresponds to a single area.

A Viterbi decoding circuit 491 decodes the coded bits (two bits) in Viterbi decoding. A delay circuit 492 delays information R. The delay circuit 492 is used to adjust the gap between the time required for Viterbi decoding at the Viterbi decoding circuit 491 and the time required for the uncoded bit decoding circuit 490 to decode uncoded bits.

After the above area decision, information R1 is expressed in four bits, so that the number of bits at the delay circuit 492 can be halved (from eight bits to four bits). To decode the delayed four bits into uncoded bits, the two Viterbi-decoded coded bits are inputted to a first decoder ROM 493.

This applies to the decoding of uncoded bits (one bit) in the first subset $S_2$. With this timing, the first multiplexer 43 selects terminal (2) with R = R2 . While in the embodiment of FIG. 11, one bit is picked up from the representative symbol of each subset to provide 4-bit representation, because there are six areas for deciding received symbols corresponding to the group of representative symbols of the subset on a one-to-one basis, they can be expressed in three bits.

Therefore, in this case, using part of (a three-bit portion of) the delay circuit 492, the second decoder ROM 494 decodes the uncoded bits (one bit) in the first subset $S_2$. Because in this embodiment, the delay circuit 492 must be of a four-bit structure to reproduce the uncoded bits in the first subset $S_2$, R2 may be expressed in four bits ($1 \times 4$) as in the embodiment of FIG. 11 and the second decoder ROM 494 may be composed of a selector that select one bit from the four bits according to the Viterbi-decoded coded bit.

In trellis decoding of $S_3$ when the first multiplexer 43 selects terminal (3), there is no uncoded bit, so that the uncoded bit decoding circuit 490 does not operate.

The uncoded bits thus decoded are time-division multiplexed by the second multiplexer 495 at the multiplexing ratio. This multiplexed output is combined with the Viterbi decoded bits outputted from the Viterbi decoding circuit 491 to form the original time-divided data strings. The demultiplexer 45 separates these into data strings Ld1, Ld2, Ld3 for the individual hierarchic levels.

The first decoder ROM 493, second decoder ROM 494, and second multiplexer 495 may be constructed of a single ROM and a control circuit that controls the time-division multiplexing process at the second multiplexer. In this case, the address input to the ROM is the output of the delay circuit 492, the Viterbi-decoded coded bits, and the output signals from the control circuit. Similarly, each signal mapping decoder and the first multiplexer 43 are constructed of a single ROM and its control circuit.

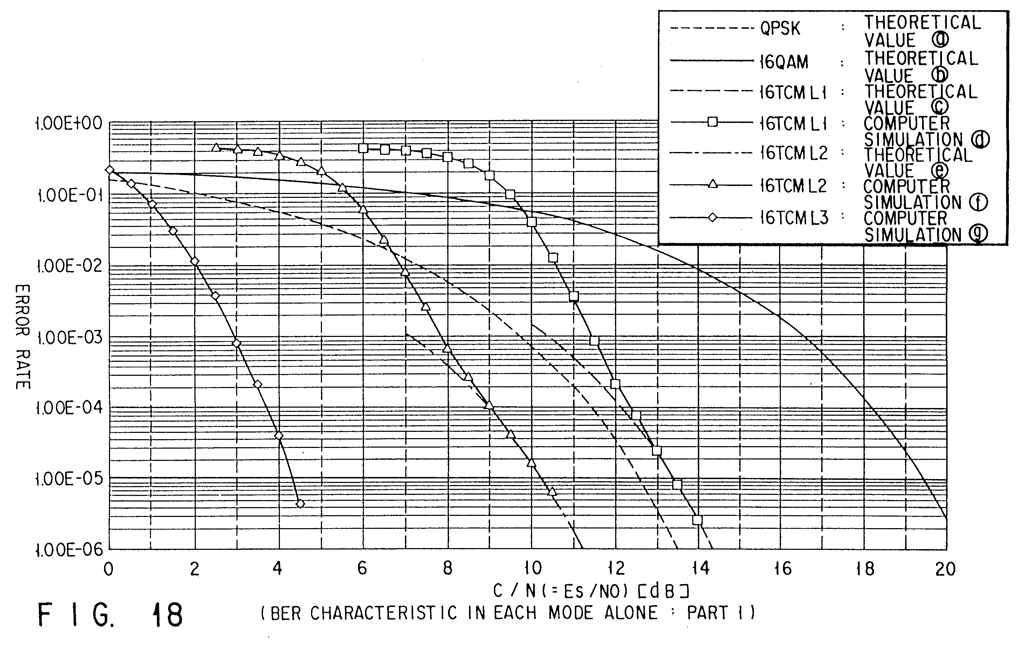

FIG. 18 shows an error rate characteristic in simulating the decoding process by a computer on the assumption that there is no error propagation in the configuration of FIG. 17. A bit error rate (BER) is used as the error rate. Since three bits of information per modulation symbol are transmitted in decoding the data string at hierarchic level L1, when C/N is acceptable, the relationship between the BER and the symbol error rate of FIG. 7 is as follows:

$$\text{BER} \fallingdotseq (\text{symbol error rate}) \div 3$$

Similarly, for the first subset $S_2$,

$$\text{BER} \fallingdotseq (\text{symbol error rate}) \div 2$$

Similarly, for the first subset $S_3$,

$$\text{BER} \fallingdotseq (\text{symbol error rate}) \div 1$$

Curve [b] indicates theoretical values of the BER characteristic in 16-QAM transmission in uncoding; curve [c] indicates theoretical values of the BER characteristic at hierarchic level L1; and curve [e] indicates theoretical values at hierarchic level L2. Curve [d], curve [f], and curve [g] indicate experimental values obtained by a computer simulation of the BER characteristic at hierarchic levels L1, L2, L3. It can be seen that curve [d] and curve [f] agree well with the theoretical values when the error rate is less than $10^{-5}$. Curve [a] is a theoretical BER curve for QPSK. Comparison of curve [a] with curve [g] shows that the characteristic is improved more than 8 dB in C/N in the range of BER $\leq 10^{-5}$. In the range of BER $\geq 10^{-3}$, errors in Viterbi decoding are dominant, so that the experimental characteristics disagree with the theoretical characteristics.

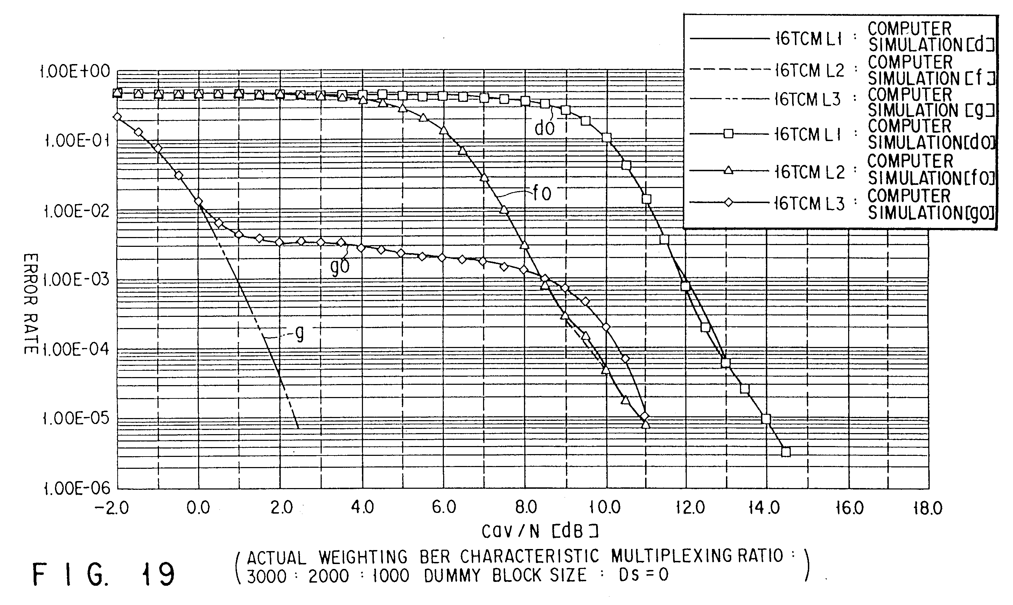

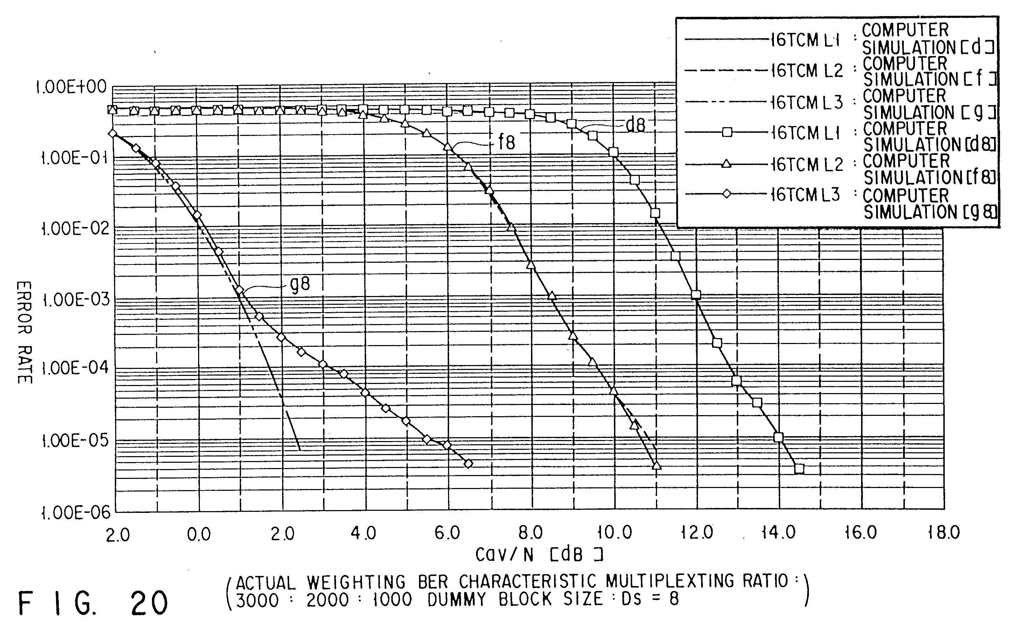

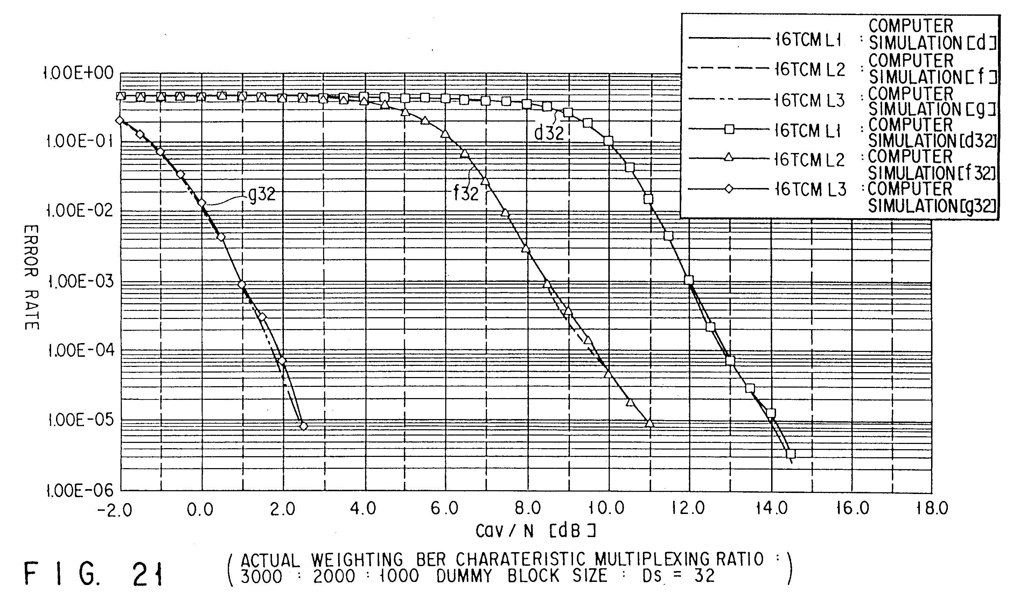

FIGS. 19, 20, and 21 show actual weighting characteristics with a multiplexing ratio of 3000:2000:1000 symbols for hierarchic levels L1, L2, L3, by changing the size of dummy block. The abscissa indicates average C/N (Cav/N). The energy of the symbols in the first subset $S_3$ of FIG. 5C is 2.5 times the average energy of FIGS. 5A and 5B. Taking this into account, the aforementioned [d] [f] [g] correspond to [d0] [f0] [g0] in FIG. 19, [d8] [f8] [g8] in FIG. 20, and [d32] [f32] [g32] in FIG. 21, respectively. The difference between hierarchic levels L2 and L3 become greater by 2.5 times the average energy. Since the energy of the received signal differs between hierarchic levels L1, L2, L3, it is correct for the weighting characteristic to have the abscissa indicating the average carrier power-to-noise power (Cav/N).

In FIG. 19, when dummy block size Ds = 0, of [d0] [f0] [g0] in the actual BER characteristic, because [g0] contains error propagation from hierarchic level L1, it deteriorates seriously from [g].

In FIG. 20, when Ds = 8, the effect of error propagation is less than when Ds = 0.

In FIG. 21, when Ds = 32, that is, when the dummy block size coincides with the computation window (= the size of path memory) of Viterbi decoding, it can be seen that there is no error propagation.

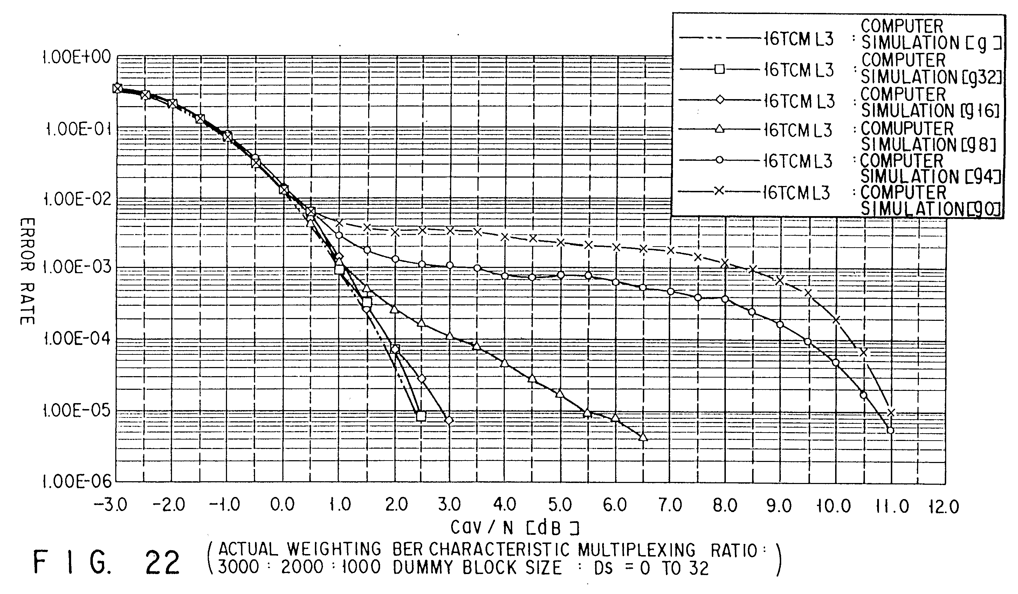

FIG. 22 shows the BER characteristic of hierarchic level L3 by changing the dummy block size in the range of Ds = 0 to 32. It can be understood that the greater Ds is, the less the effect of error propagation is.

Still another embodiment of the present invention will be explained.

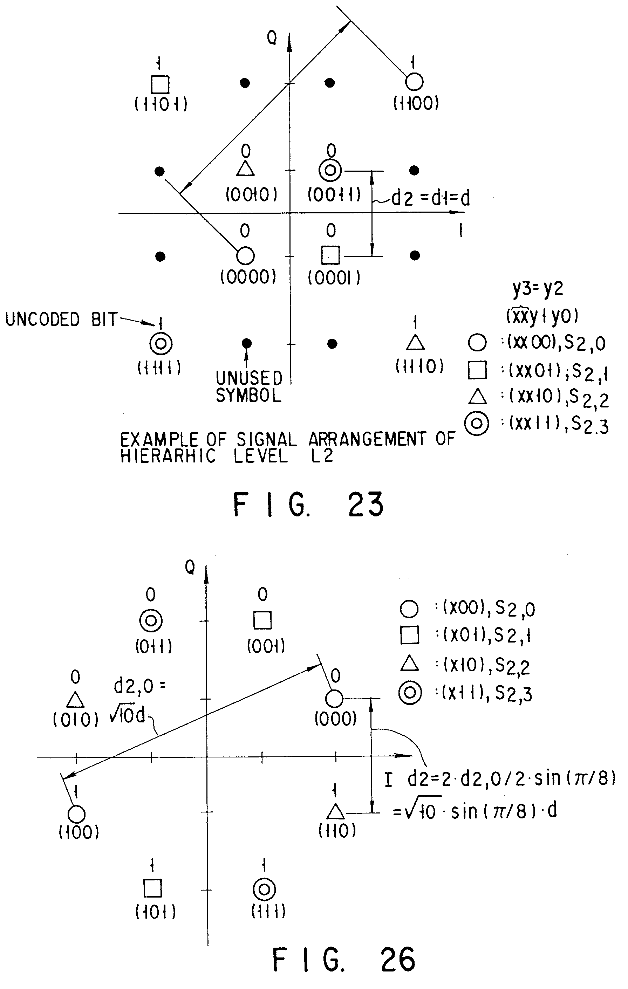

FIG. 23 shows another embodiment of the signal mapping at hierarchic level L2.

While in the embodiment of FIG. 6A, the first minimum Euclidean distance meets the expression d1 < d2, in the embodiment of FIG. 23, however, it meets the equation d1 = d2 . There is no difference in the second minimum Euclidean distance between FIG. 6A and FIG. 23.

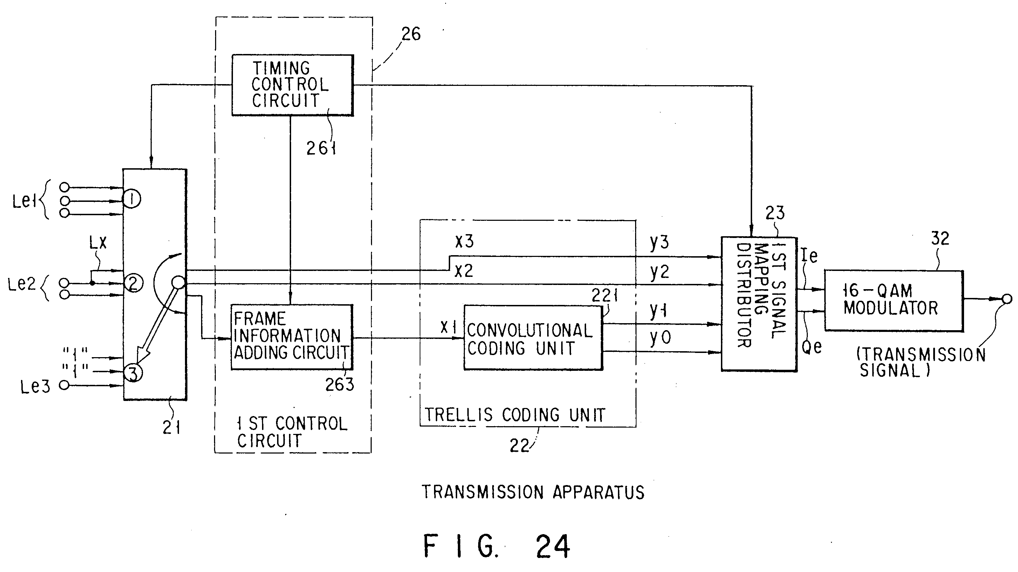

FIG. 24 shows an embodiment of the multilevel weighted transmission apparatus in using the signal mapping at hierarchic level L2 as shown in FIG. 23. Since in this embodiment, the signal mapping is common to $S_1$, $S_2$, $S_3$, the configuration can be made simpler than those of the second and third embodiments shown in FIGS. 8, 9, and 10. Specifically, the outputs x3 and x2 of the multiplexer 21 are supplied as y3 and y2 to the signal mapping distributor 23. The output x1 of the multiplexer 21 is added with the frame information at the frame information adding circuit 263 and then is expanded at the convolutional coding unit 221, which then supplies the results as y1 and y0 to the signal mapping distributor 23. The Ie and Qe components outputted from the signal mapping distributor 23 are digitally modulated at the 16-QAM modulator 32, which outputs the modulated signals. The apparatus is characterized in that with the Le2 transmission timing, the equation x3 = x2 is met to give y3 = y2 .

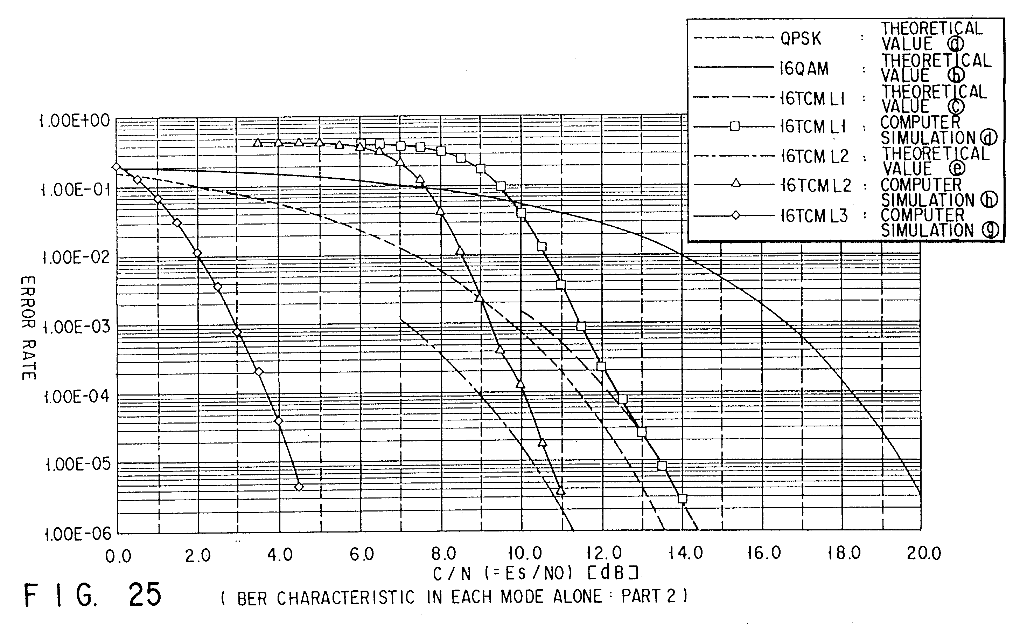

FIG. 25 shows the BER characteristic of the apparatus of FIG. 24 simulated by a computer (the characteristic of hierarchic level L2 corresponds to curve [h]). As compared with curve [f] in FIG. 18, Viterbi decoding errors are particularly dominant. The characteristic is worse in the range of BER $\geqq 10^{-3}$. This is attributable to the fact that while the signal mappings of FIGS. 6A and 17 meet the expressing d2 < d1, the signal mapping of FIG. 23 meets the equation d2 = d1 . That is, Viterbi decoding errors depend on the first minimum Euclidean distance.

Still another embodiment of the present invention will be explained.

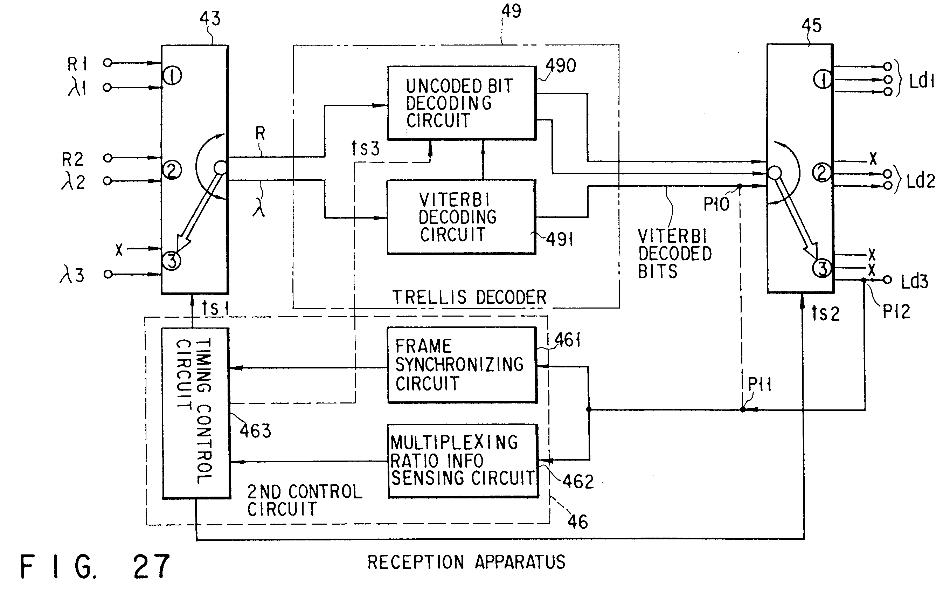

In FIG. 26, the signal mapping at hierarchic level L2 is the signal mapping for 8-PSK. If the average energy of modulation symbols for 16-QAM in the first subset $S_1$ is equal to the average energy of modulation symbols for 8-PSK of FIG. 26, the first minimum Euclidean distance d2 will be:

$$d2 = (\sqrt{10}) \times \sin(\pi/8) \cdot d \fallingdotseq 1.2d1 \ (d1 = d)$$

the second minimum Euclidean distance d2,i will be:

$$d2,i = (\sqrt{10}) \times d = (\sqrt{10}) \times d1,i \ (i = 0, 1, 2, 3)$$

When attention is given only to the second minimum Euclidean distance, the distance is still larger than d2,i = $(\sqrt{2}) \times$ d1,i, (i = 0, 1, 2, 3) in the signal mapping of FIG. 6A, so that the characteristic is improved by about 1 dB in C/N. This holds true only in the range where C/N is so good that errors in Viterbi decoding can be ignored (e.g., BER $\geqq 10^{-5}$).

In the range where Viterbi errors are dominant, the first minimum Euclidean distance is d2 $\fallingdotseq$ 1.2d1 in the present embodiment, whereas it is d2 = $\sqrt{2}$d1 $\fallingdotseq$ 1.41 d1 in the embodiment of FIG. 6A, so that the characteristic of the present embodiment is worse a little.

The universal set U in the present embodiment corresponds to the sum of constellations for 16-QAM and 8-PSK, giving U = $S_1 \cup S_2 \ (S_1 \supset S_2)$ . It should be noted that U $\supset S_1 \ (U \neq S_1)$.

As described above, with the present invention, it is also possible to work out the sum of different digital modulation schemes to form the universal set U, achieving compatibility with the respective modulation schemes without changing the design.

Still another embodiment will be explained.

FIG. 27 shows a configuration of the trellis decoder and its peripheral circuitry in the reception apparatus in a system where the frame information (multiplexing ratio information, frame synchronizing coding block, or dummy block) is added.

Although the frame information is multiplexed to hierarchic level L3 whose error characteristic is the best (see the timing chart of FIG. 13), because it contains convolutional coding, the frame synchronization establishing process at the frame synchronizing circuit 461 and the sensing of multiplexing ratio information at the multiplexing ratio information sensing circuit 462 can be performed using Viterbi decoded bits.

In the period of dummy block, modulation symbols in the first subset $S_3$ in a one-bit per modulation symbol transmission are used. When the Viterbi decoding process (computation of branch metrics and path metrics or updating process of paths) in that period is continued, the setting of a suitable dummy block period allows errors to have completed propagating from hierarchic level L1 in the dummy block period. If the data string multiplexed in the dummy block period is dummy data, the dummy block data string contained in the Viterbi bits will not be used.

If the data multiplexed in the dummy block period is part of the data in Le1, the demultiplexer 45 will return the data string in the dummy block contained in the Viterbi decoding bits.

When an uncoded bit decoding circuit 490 of FIG. 27 has the same configuration as that of the uncoded bit decoding circuit 490 of FIG. 17, control of time-division multiplexing at the multiplexer 495 of FIG. 17 will be carried out by the output ts3 (represented by dotted line in the figure) of a timing control circuit 463 of FIG. 27. The operation in this case is the same as in FIG. 17. When the ratio of time-division multiplexing is changed frequently, it is desirable that the frame length should be fixed.

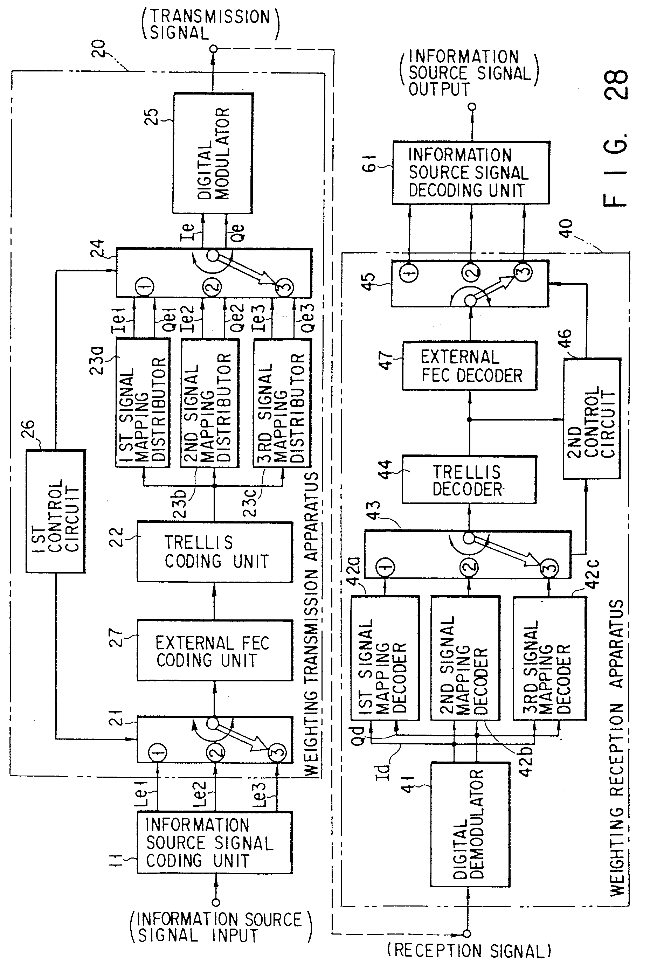

FIG. 28 shows a transmission and a reception apparatus according to still another embodiment of the present invention.

Most of the configuration of this embodiment is the same as that of FIG. 3. An FEC coding unit 27 is provided between the multiplexer 21 and the trellis coding unit 22. On the reception side, an FEC decoder 47 is provided between the trellis decoder 44 and the demultiplexer 45.

In the trellis decoding output, once a mistake has been made in selecting a path for Viterbi decoding, it takes a long time to return to the proper path, permitting burst errors to take place. To overcome this problem, a trellis coding/decoding unit is provided inside and an external FEC coding unit 27 and an external FEC decoder 47 are provided outside as shown in FIG. 28, thereby employing concatenated coding/decoding using RS (Reed-Solomin) coding/decoding suitable for burst errors. In the present embodiment, the external FEC coding unit 27 and the external FEC decoder 47 are common to three levels of hierarchy. The remaining portion is the same as the configuration of FIG. 3 and the same parts as those of FIG. 3 are indicated by the same reference symbols.

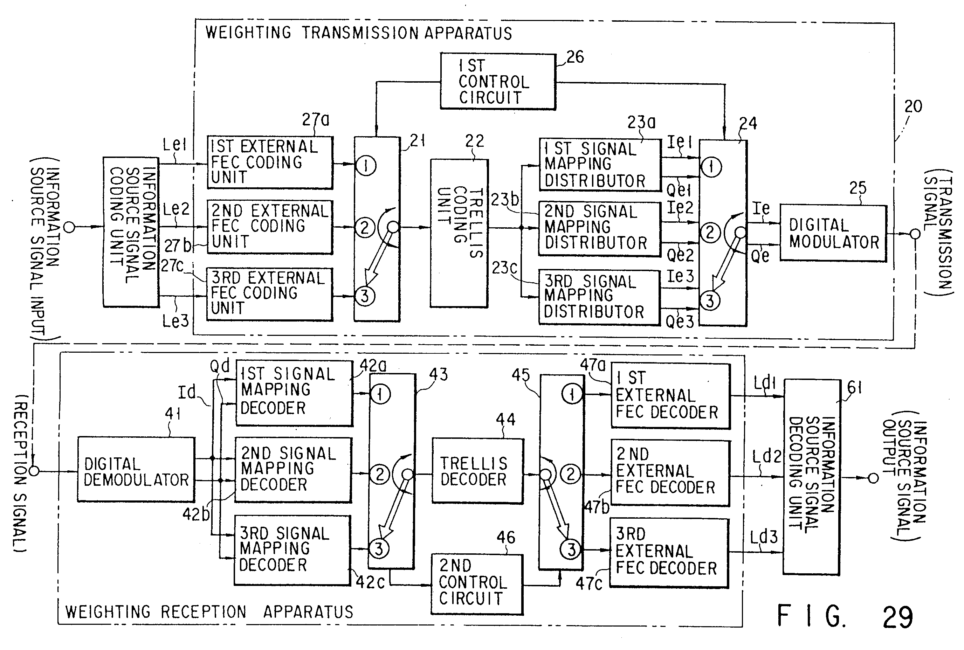

FIG. 29 shows still another embodiment of the present invention.

In this embodiment, a trellis coding unit 22 and a trellis decoder 44, which perform internal FEC coding/decoding, operate in time division and are common to each level of hierarchy. Furthermore, an external FEC coding/decoding unit is provided for each level of hierarchy. This is effective in making larger the difference in the characteristic between transmission channels for the individual hierarchic levels. In this embodiment, external FEC coding units 27a, 27b, 27c are provided between the information source signal coding unit 11 and the individual input terminals (1), (2), (3) of the multiplexer 21. Furthermore, external FEC decoders 47a, 47b, 47c are provided between the individual output terminals (1), (2), (3) of the demultiplexer 45 and the information source signal decoding unit 61. The remaining portion has the same configuration as that of FIG. 3.

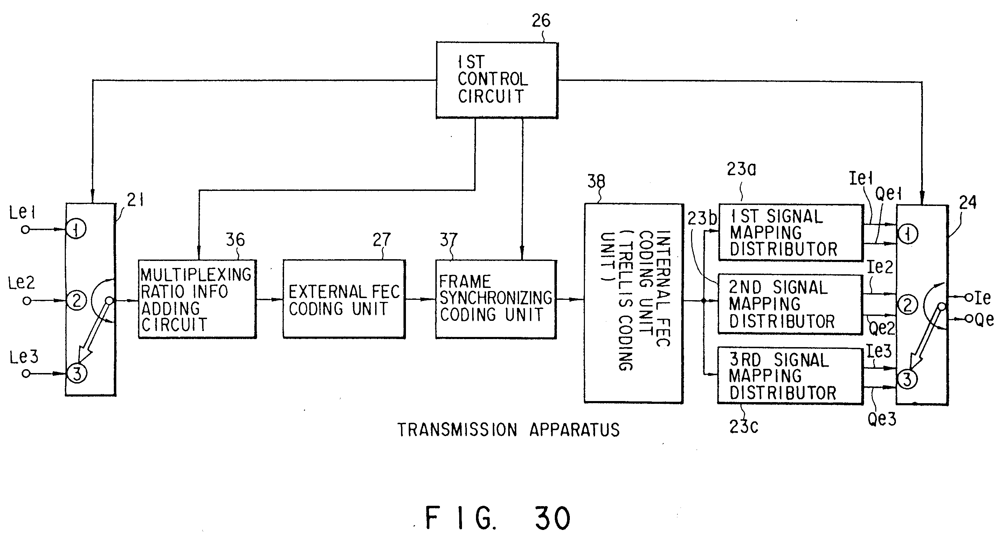

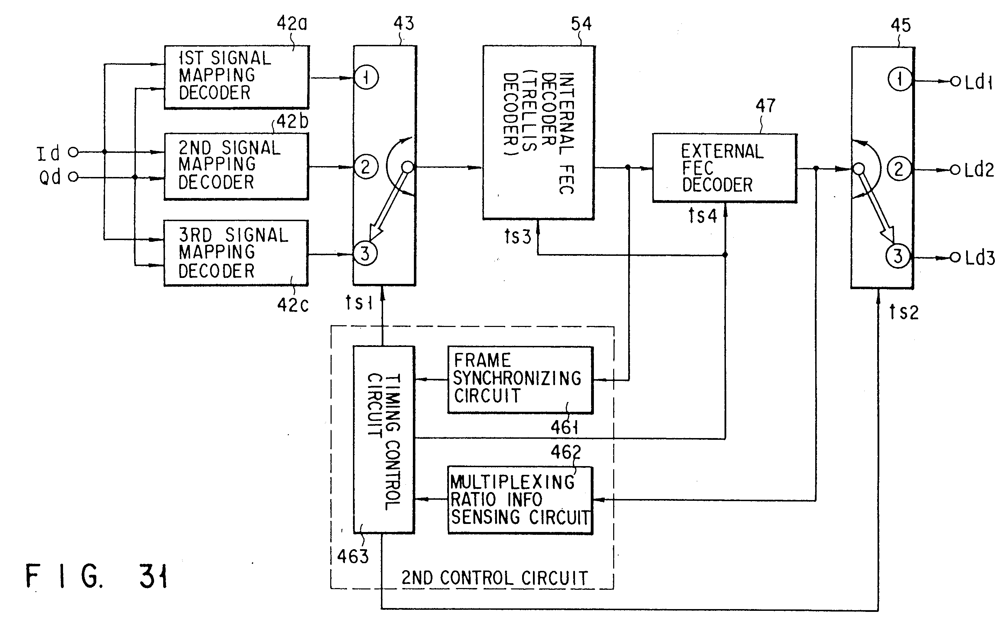

FIGS. 30 and 31 show a transmission and a reception apparatus according to still another embodiment of the present invention.

FIG. 30 shows the configuration of part of a multilevel weighted transmission apparatus where the frame information (information on the multiplexing ratio, frame synchronizing code, or preamble) is added when FEC coding is effected by concatenated coding using internal FEC coding and external FEC coding. FIG. 31 shows a corresponding multilevel weighted reception apparatus.

In the transmission apparatus, a multiplexing ratio information adding circuit 36, an external FEC coding unit 27, a frame synchronizing code adding circuit 37, and a trellis coding unit 38 are provided in that order on the output side of the multiplexer 21. The timing at each section is controlled by the first control circuit 26.

In the reception apparatus, the output of the multiplexer 43 is inputted to a trellis decoder 54 (internal FEC encoder). The output of the decoder 54 is inputted to an external FEC decoder 47. The output of the decoder 47 is inputted to a demultiplexer 45. The output of the trellis decoder 54 is also supplied to a frame synchronizing code sensing circuit 461. The output of the external FEC decoder 47 is also supplied to a multiplexing ratio information sensing circuit 462. The outputs of these sensing circuits 461, 462 are inputted to a timing control circuit 463.

For example, RS codes are used in external FEC coding.

At this time, the addition of the multiplexing ratio information is effected at the stage before external FEC coding and the addition of frame synchronizing codes is effected after external FEC coding and before internal FEC coding. The addition of dummy blocks can be effected either before or after external FEC coding, provided that it is before internal FEC coding (trellis coding).

On the reception side, the data string after the internal FEC decoding is introduced into the frame synchronizing circuit 461 to establish a frame synchronization and thereafter the output data string after the external FEC decoding is used to sense the multiplexing ratio information. The output signals ts3 and ts4 from the timing control circuit 43 are used to control the decoding timing for each of the internal FEC decoder (trellis decoder) 54 and the external FEC decoder 47. Furthermore, when block codes are used in external FEC coding, it is convenient if the frame period is an integral multiple of the period of one block of external FEC coding data.

When concatenated coding is used, to enhance the effect of external FEC coding, interleaving may be done after external FEC coding and deinterleaving may be done before external FEC decoding.

Since the trellis coding/decoding scheme is suitable for random errors, in many cases, interleaving is effected after trellis coding and deinterleaving is effected before trellis decoding to make burst errors on the transmission channel random.

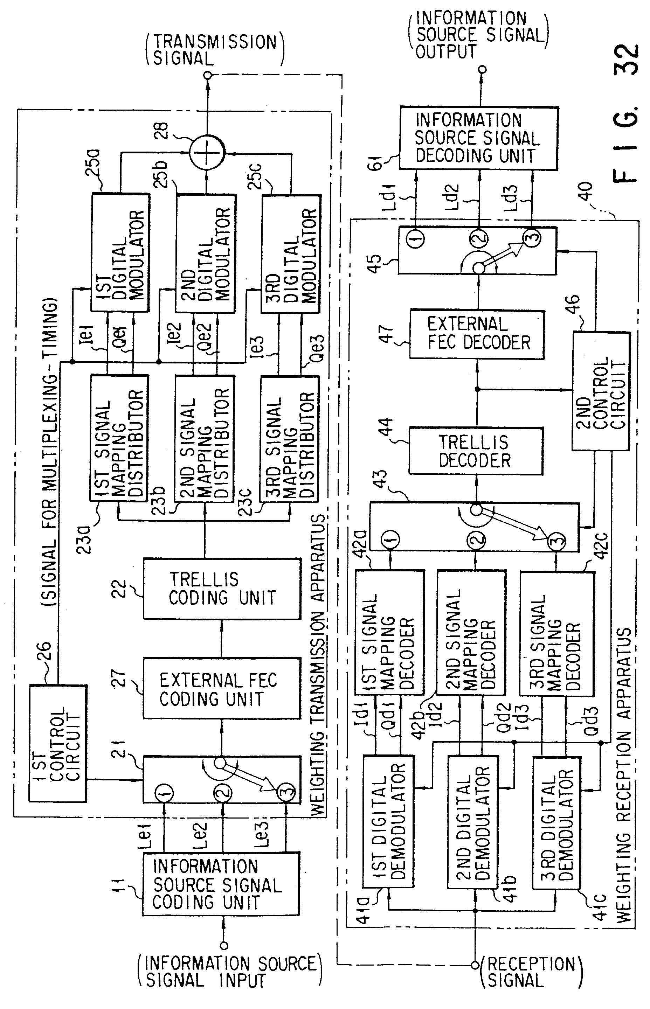

FIG. 32 shows still another embodiment of the present invention.

In this embodiment, each level of hierarchy is provided with digital modulators 25a, 25b, 25c and digital modulators 41a, 41b, 41c. Specifically, in the transmission apparatus, the output of a first signal mapping distributor 23a is supplied to the first digital modulator 25a; the output of a second signal mapping distributor 23b is supplied to the first digital modulator 25b; and the output of a third signal mapping distributor 23c is supplied to the third digital modulator 25c. The outputs of the digital modulators 25a, 25b, 25c are supplied to an adder 28. In the reception apparatus, the received signal is supplied to a first, second, and third digital demodulators 41a, 41b, 41c. The demodulated output of the first digital demodulator 41a is supplied to a first signal mapping demodulator 42a; the demodulated output of the second digital demodulator 41b is supplied to a second signal mapping demodulator 42b; and the demodulated output of the third digital demodulator 41c is supplied to a third signal mapping demodulator 42c. The remaining portion is the same as that of FIG. 3.

In the embodiments described above, the digital modulator/demodulator is shared by the individual levels of hierarchy and used in time division. Therefore, the quality of carrier reproduction and clock reproduction is limited by the hierarchic level whose transmission error rate is the worst, so that a very high-performance digital demodulator is needed. In a scheme where pilot carrier is transmitted separately as in the VSB-AM scheme (see "NCTA TECHNICAL PAPERS," pp. 271-279, 1993), the problem encountered in reproducing carriers will not arise. Furthermore, clock reproduction may be simplified by transmitting the symbol clock with another carrier.

The present embodiment, however, is characterized by requiring no high-performance powerful digital modulator even if the symbol clock is not transferred with another carrier.

Namely, the carrier and clock reproduced at the low priority level digital modulator are used as the carrier and clock for a higher-level digital modulator. For example, if in FIG. 32, the ratio of the first, second, and third digital modulation carrier frequencies f1, f2, f3 is 3:2:1, a simple integral ratio, the third digital modulator 41c corresponding to the third digital modulation carrier frequency f3 at the low priority level is designed to reproduce a signal of a frequency of $fc = 6 \times f3$, the least common multiple of f1, f2, and f3. That is, fc is sexisected to produce a sine-wave signal of f3, and a PLL (phase lock loop) phase-locked on this signal is formed to reproduce the carrier, thereby reproducing the signal with a frequency of fc.

f1 can be obtained by bisecting fc and f2 can be obtained by trisecting fc. In clock reproduction, by causing the clock frequency to coincide with the symbol clock frequency on the transmission side, the clock reproduced at the third digital modulator 41c can be used at the first and second digital modulators 41a, 41b.

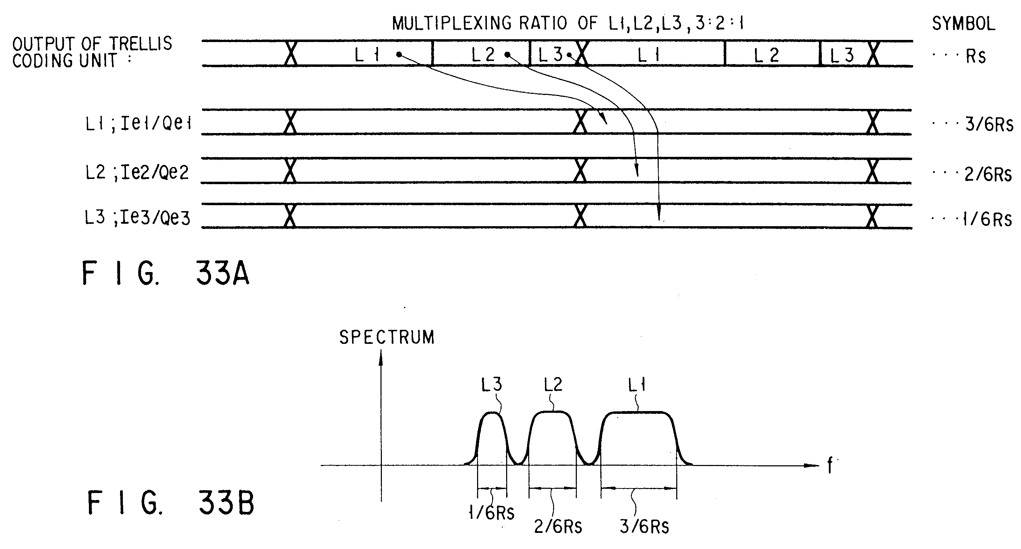

It is assumed that each of the first, second, and third digital modulators 41a, 41b, 41c contains a speed change function controlled by the first control circuit so that the individual hierarchic levels may be consecutive according to the multiplexing ratio of the hierarchic levels and therefore the transmission frequency band may be the minimum. The timing is shown in FIG. 33A. FIG. 33B shows a spectrum of hierarchic levels L1, L2, L3.

The symbol clock of digital modulation at the individual levels of hierarchy is controlled according to the multiplexing ratio so that the symbol clock may be consecutive at hierarchic levels L1, L2, L3. With a certain timing, for example, by putting the end of a symbol on the beginning of a frame, the reconstructed clock in least level (highest prior) layer can be reproduced using the clock reproduced at the low priority level on the decoding side. On the reception side, the second multiplexer 43 time-division multiplexes the signals of the individual hierarchic levels to effect trellis decoding of these outputs. The speed conversion on the transmission side may be performed by the respective mapping distributors 23a, 23b, 23c.

If the speed conversion is not implemented, each level of hierarchy will need a spectrum bandwidth of Rs [Hz], which is uneconomical (the frequency utilization gets worse).

In the present embodiment, as many digital modulators and demodulators as there are hierarchic levels are provided. Since this approach works as long as the carrier reproduction is independent from clock reproduction at the low priority level, for example, digital modulators and demodulators may be provided for two levels of hierarchy and those at hierarchic level L1 may be shared. That is, for example, the first and second digital modulators 25a, 25b may be grouped into one modulator and operated in time-division. Furthermore, the first and second digital demodulators 41a, 41b may be grouped into one demodulator and operated in time-division.

Furthermore, by weighting the transmission power of each carrier, the difference in the characteristic between hierarchic levels.

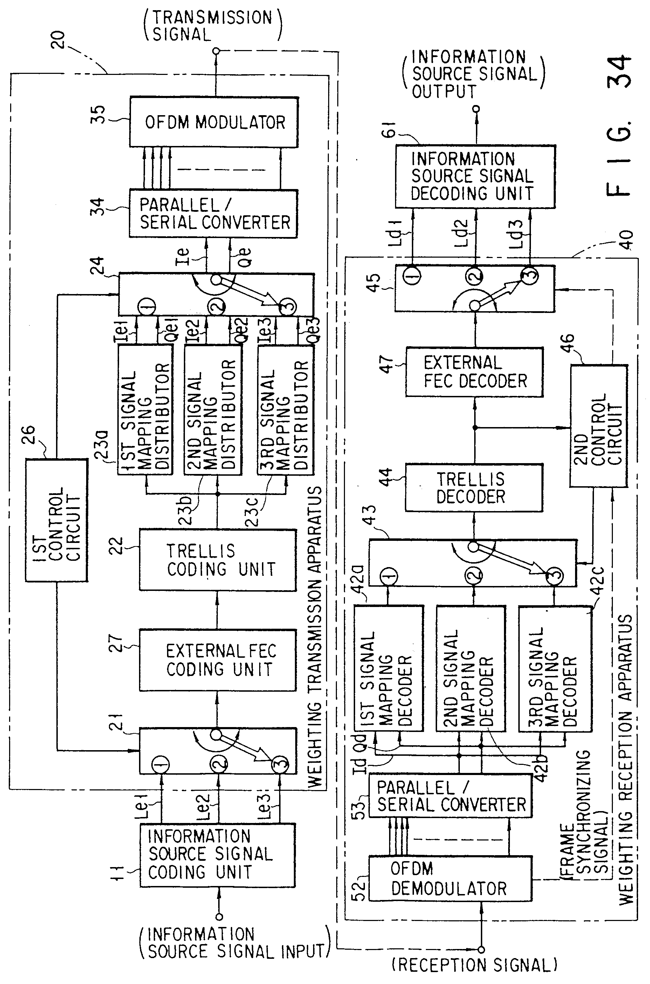

FIG. 34 shows another embodiment of the present invention.

In this embodiment, the OFDM (orthogonal frequency division multiplexing) modulation scheme is used in digital modulation. With this, a multilevel weighted transmission scheme suitable for multipath can be realized. In the transmission apparatus, the output of the multiplexing 24 is supplied to a serial-parallel converter 34. The output of the converter 34 is supplied to an OFDM modulator 35. In the reception apparatus, the received signal is inputted to an OFDM demodulator 52. The modulated output of the modulator 52 is inputted to a parallel-serial converter 53. The Id and Qd from the converter 53 are supplied to the first to third signal mapping demodulators 42a, 42b, 42c. The remaining portion is the same as that of FIG. 3.

Generally, in the OFDM modulator 35, a certain number of symbols are grouped into one frame. On the reception side, by sensing the null symbol and reference symbol inserted on the transmission side, the frame synchronization for the reception apparatus is established. Thus, framing is done in advance in OFDM modulation and demodulation, so that by forcing the synchronization of time-division multiplexing at each hierarchic level to coincide with the frame synchronization, it is not necessary establish frame synchronization again at the second control circuit 46.

For example, if the frame synchronization in time-division multiplexing coincides with the frame synchronization of OFDM or is 1/n (n = an integer) the length of the frame synchronization, timing control of time-division multiplexing and demultiplexing can be performed by using the frame synchronizing signal established at the OFDM modulator 52. Thus, as shown by dotted lines in the figure, the frame synchronizing signal obtained at the OFDM modulator 52 can be introduced into the second control circuit 46.

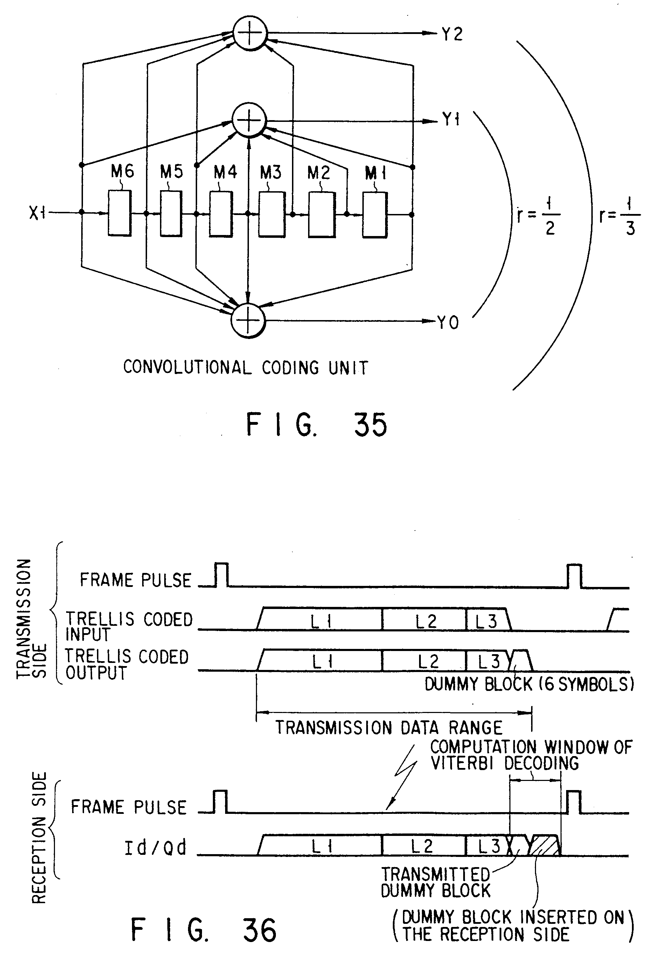

FIG. 35 shows an example of the convolutional coding unit and FIG. 36 is a timing chart to help explain the operation of the coding unit.

In the embodiments described so far, a condition for preventing error propagation from taking place is that as many dummy blocks as correspond to the Viterbi decoding computation window (=the length of path memory) should be inserted into the data string. In addition to this, error propagation can be prevented by transmitting at least dummy blocks of symbols (the number corresponding to the constraint length of convolutional coding - 1) and .

FIG. 35 shows an example of a feed-forward convolutional coding unit. In the convolutional coding unit of FIG. 35, the rate (r) is r = 1/2 and 1/3, and the finite memory length to obtain convolutional generating functions Y0, Y1, Y2 is the constraint length of code. If the memory length (M1 to M6) of a coding unit is past six bits, the present input bit will be added to it to provide a constraint length k of 7. If the data (x1) in the dummy block is x1 = 0, the dummy block of six symbols will be only inserted into the data string and each register in the convolutional coding unit will be cleared (M1 to M6 are all zero). This will give y1, y0 = 0. If the computation window in Viterbi decoding has 32 symbols, this will give (y1, y0) = (00) even if a dummy block of the remaining 26 symbols is inserted into the data string. Six symbols before each register contains zero only must be transmitted as the last six symbols in the data string at hierarchic level L3. Even if the dummy block of the remaining 26 symbols has been inserted, (y1, y0) = (0 0) remains unchanged, so that the dummy block of the remaining 26 symbols is not necessarily transmitted.

FIG. 36 is a timing chart to help explain the operation of the convolutional coding unit of FIG. 35. The dummy block determined in the transmission and reception of six symbols is added to the input of one frame in the trellis coding unit at hierarchic levels L1, L2, L3. Only six symbols (the number corresponding to the constraint length in convolutional coding, 7 -1) are obtained for the dummy block. According to the agreement between transmission and reception, if the digital modulator or the third multiplexer 43 inserts a dummy block of the known remaining 26 symbols, this will be equivalent to inserting a dummy block for the computation window in Viterbi decoding (see the shaded portion in FIG. 36). If the dummy block meets x1 = 0, the dummy block inserted on the reception side of FIG. 36 will meet Id/Qd corresponding to (y1 y0) = (0 0) .

The problem is how to establish frame synchronization. If the digital modulation scheme is an OFDM modulation scheme as in the embodiment of FIG. 34, frame synchronization can be established by the OFDM modulator 52. Using the frame pulse obtained from the modulator 52, the second control circuit 46 controls the timing of the dummy block inserted on the reception side.

In this way, frame synchronization can be established by the signal or data string before trellis decoding. If convolutional coding in trellis decoding is of the feed forward type, the dummy block of the size of (the number corresponding to the restraint length in convolutional coding - 1) can be inserted relatively easily into the demodulated output.

When the frame of time-division multiplexing signal is 1/nf the frame in the OFDM system, the remaining dummy block (26 symbols) is inserted into the rear end of each frame of time-division multiplexing signal, that is, nf times.

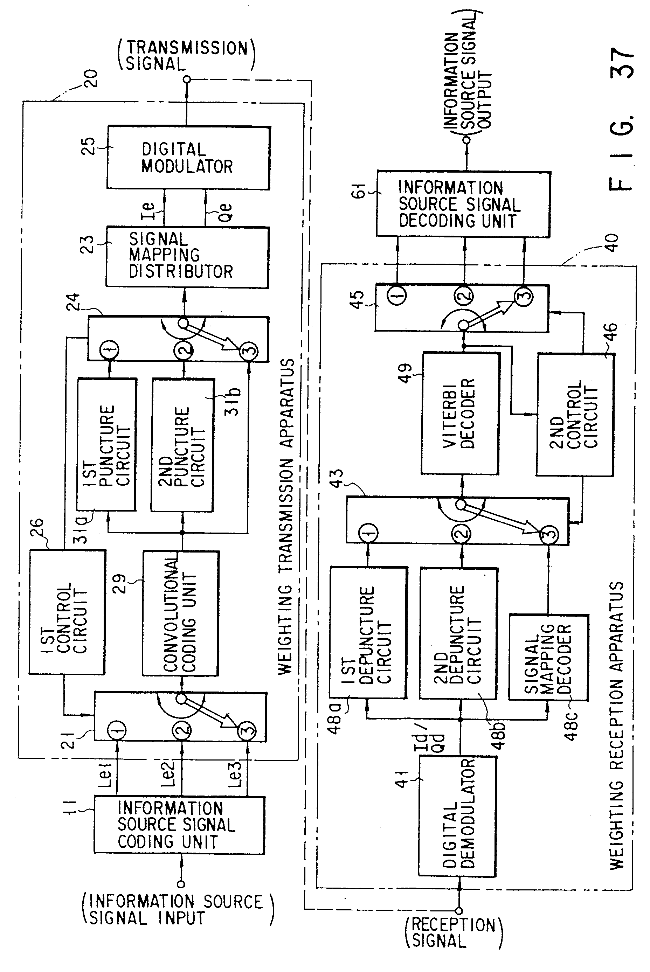

FIG. 37 shows still another embodiment of the present invention.

Even if punctured coding with a different coding rate instead of the trellis-coded modulation scheme, similar multilevel weighted transmission is possible. In this case, too, the order of multiplexing is determined to be ascending order of the quality of error characteristic. Insertion of a dummy block prevents error propagation.

In FIG. 37, convolutional coding is effected at the convolutional coding unit (a coding rate r = 1/2) of FIG. 35 and the output of the coding unit is used as it is in transmission of hierarchic level L3. In this case, the digital modulation scheme is QPSK.

A first puncture circuit 31a has a coding rate of 3/4 and generates eight bits of data for four QPSK modulation symbols, using the four-bit input convolutionally coded.

A second puncture circuit 31b has a coding rate of 2/3 and generates six bits of data for three QPSK modulation symbols, using the four-bit input convolutionally coded.

On the reception side, a first depuncture circuit 48a generates a branch metric for 12 bits of convolutional coding (six symbols) from four QPSK modulation symbols.

A second depuncture circuit 48b generates a branch metric for 8 bits of convolutional coding (four symbols) from three QPSK modulation symbols.

In the above embodiment, the following modification can be considered.

Instead of convolutional coding with r = 1/2 of FIG. 4B, punctured coding with r > 1/2 may be used. In this case, the coding rate for the entire trellis coding is larger. The effect of doing this way has been disclosed in detail in reference [3]: Tanaka and Matsushima, "An Application of Trellis Coded Modulation to Digital Microwave Radio and Its Performance," Proceedings of ICC' 93, pp. 128-132, May 1993.

Furthermore, a plurality of punctured codes with r = 1/2 being the original code may be allocated to each level of hierarchy. For example, convolutional coding with r = 1/2 is allocated to hierarchic levels L1 and L2 and punctured coding is allocated to hierarchic level L3 in FIG. 5. In this case, the original code is the same, the Viterbi decoding section excluding BMU can be shared.

Furthermore, as a modification of the embodiment of FIG. 37, codes whose constraint length is the same and whose coding rate differ from each other may be time-division multiplexed in ascending order of the quality of transmission error characteristic. For example, in the case of convolutional codes (y1, y0) and (y2, y1, y0) with r = 1/2 and r = 1/3 in FIG. 35, r = 1/3 provides a better transmission characteristic. The individual codes thus obtained have the same constraint length, so that in a decoding process, they can share the Viterbi decoding section excluding BMU. A combination of punctured coding with r = 1/2 and r = 1/3 being the original codes can be considered.

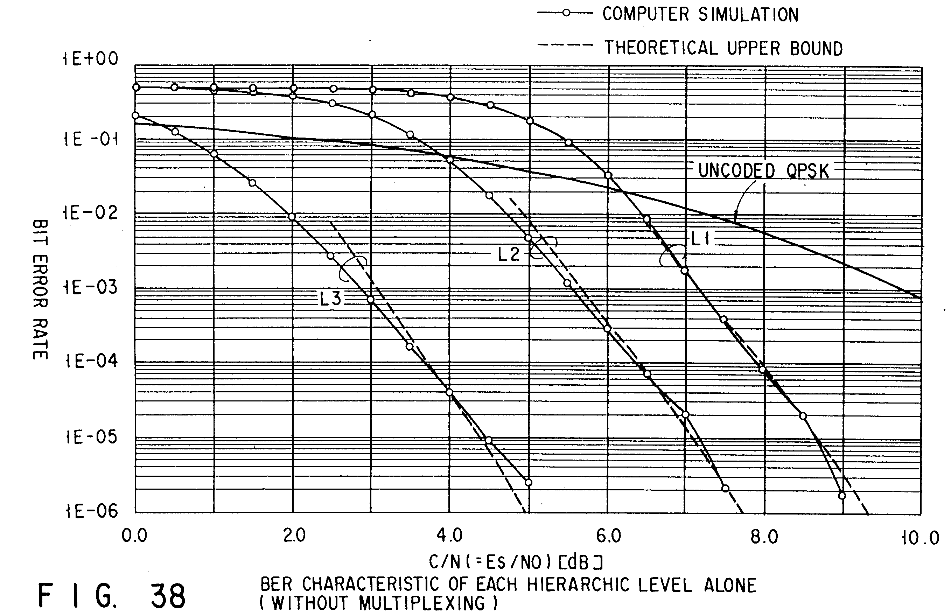

FIG. 38 shows a characteristic only for punctured codes with r = 1/2 and a constraint length of 7 being the original code. In the figure, L1 is for a coding rate of r = 7/8, L2 is for a coding rate of r = 3/4, and L3 is for a coding rate of 1/2. The dotted lines indicate theoretical boundary values. This has been disclosed in reference: Yasuda, Hirata, and Ogawa, "Easy, High-coding Rate Convolutional codes in Viterbi Decoding and its Characteristics," --- (B), vol. J64-B, No. 7, pp. 573-580, Jul. 1981.

Since attention is paid to weighting information, the abscissa is converted into C/N (precisely, Es/No) for the purpose of making the difference in weighting distinctive. The modulation scheme is the QPSK scheme. Because the individual levels of hierarchy use the same modulation scheme, the average C/N is equal to the C/N (= Es/No) for each hierarchic level.

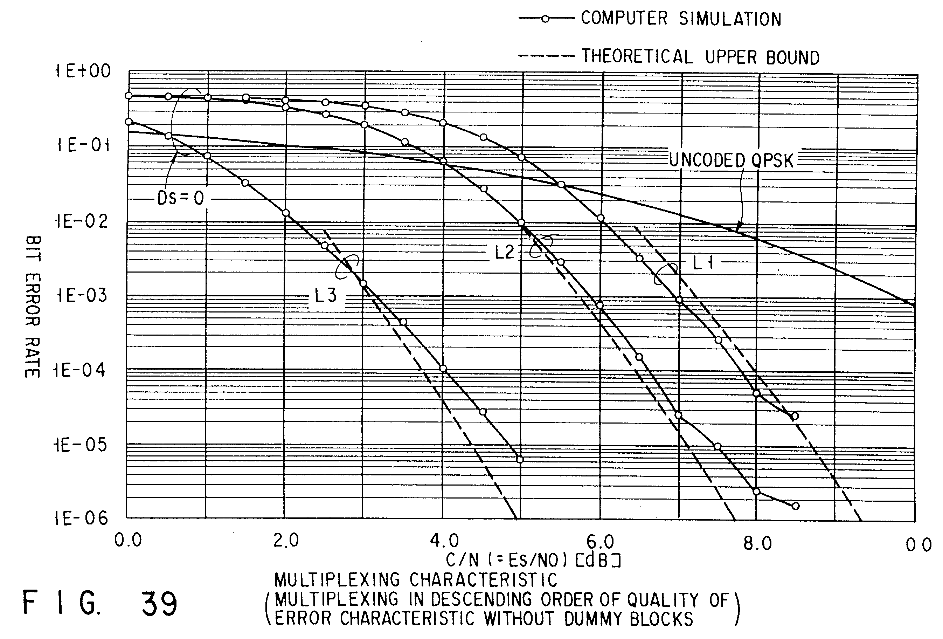

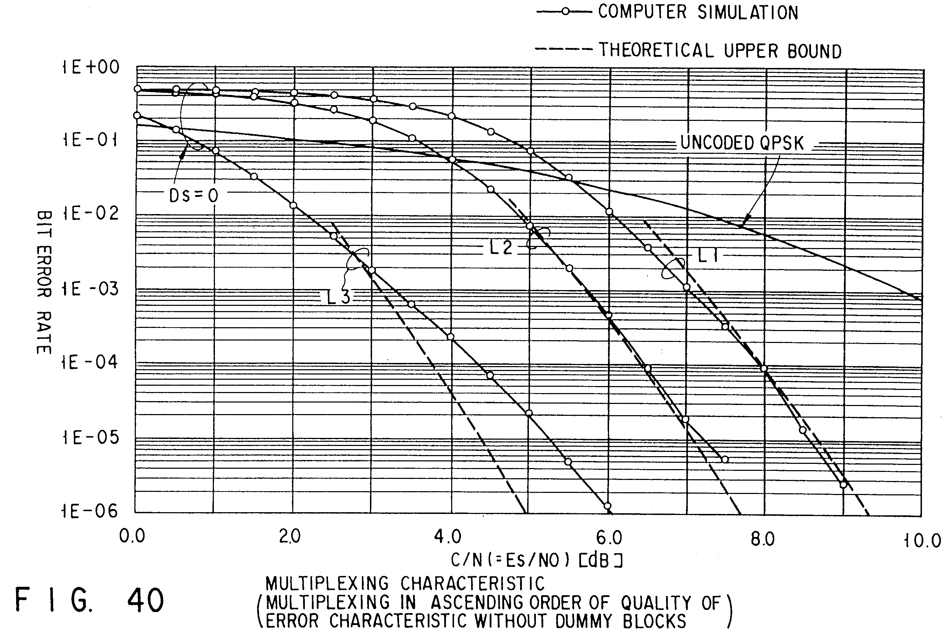

FIGS. 39 and 40 show the characteristics of transmission error rate in a transmission and reception system in a case where one frame is formed with 98 bits for L1, 102 bits for L2, and 308 bits for L3 and is then multiplexed. In an example of transmission, there is no dummy block. Explanation of transmission characteristic has been given in FIGS. 12A and 12B.

FIG. 39 shows a characteristic in the case where the order of multiplexing is descending order of the quality of transmission error characteristic (L3, L2, L1, L3, L2, ...). FIG. 40 shows a characteristic in the case where the order of multiplexing is ascending order of the quality of transmission error characteristic (L1, L2, L3, L1, L2, ...).

As seen from the characteristic of FIG. 39, L1 is influenced by error propagation in L3, L2 is influenced by error propagation in L1, and L3 is influenced by error propagation in L2, so that the characteristic is poorer than the theoretical values. The characteristic of FIG. 40 shows that L3 is influenced only by error propagation in L1 and the characteristics of L1 and L2 of FIG. 40 are closer to the theoretical values than the characteristics of L1 and L2 of FIG. 39. The characteristic of L3 of FIG. 39, however, is better than that of FIG. 40. The reason for this is that in the case of descending order of the quality of transmission error characteristic, L3 is influenced by error propagation in L2, whereas in the case of ascending order of the quality of transmission error characteristic, L3 is influenced by error propagation in L1, meaning that L1 has a poorer transmission characteristic than L2.

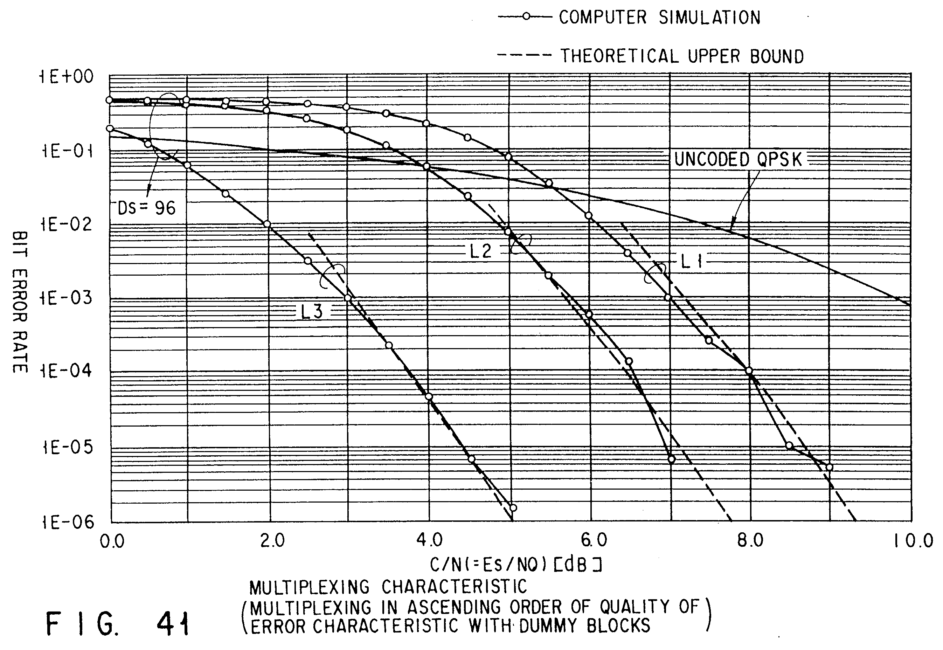

FIG. 41 shows a characteristic in a case where transmission is carried out with a dummy block added. Specifically, FIG. 41 shows the characteristic of transmission error rate in a transmission and reception system in a case where one frame is formed with 96 bits for dummy block Ds, 98 bits for L1, 102 bits for L2, and 308 bits for L3 and is then multiplexed. The order of transmission is ascending order of the quality of transmission error rate (L1, L2, L3, D, L1, L2, L3, D, ...) and dummy block D is contained.

The number of stages of path memory corresponding to high-rate punctured codes, for example, codes with r = 7/8, must be about 100, so that the dummy block length is determined to be 96 bits to match with the stages. In simulation, the number of stages of path memory was determined to be 96.

The effect of error propagation in L1 is absorbed in dummy block D, preventing error propagation in L1 from having an adverse effect on L3. Because L3 is influenced by D, D is transmitted according to a transmission characteristic ($r \geq$ 1/2) equal to or better than that of L3. FIG. 41 is a characteristic diagram in the case where dummy block D is transmitted at r = 1/2, showing there is no effect of error propagation.

In this embodiment, feed-forward convolutional coding is used, so that the actually transmitted dummy block contains six bits. For example, six bits of "0" is subjected to convolutional coding and coded symbols for six symbols are transmitted.

In decoding, a branch metric corresponding to the remaining (96 - 6) = 90 symbols is added to a branch metric for six symbols obtained from the received signal through computation and then Viterbi decoding of the received signal is started. The added branch metric corresponds to coded bit (0 0).

In an actual application system, for example, when audio compressed data is subjected to error correction coding and then transmitted, important data (S) such as scale factors may be transmitted in a hierarchic level whose error characteristic is good, and the other data (A) may be transmitted in a hierarchic level whose error characteristic is poorer. Namely, transmission may be carried out in such a manner that | ... ASD | ... ASD | ... ASD | ... On the reception side, however, the scale factor is needed first of all. In this case, to get the scale factor, A may be replaced with S before decoding and S is decoded earlier or the operation may proceed one frame ahead and S be transmitted.

As described above, with the present invention, in a coding and decoding apparatus with a hierarchic structure, the number of error correction encoders can be reduced to one without introducing error propagation in convolutional coding.

With a method and a transmission and a reception apparatus according to the present invention, when modulation symbols constituting a constellation for digital modulation is divided into subsets (hereinafter, referred to first subsets), it is possible to make the transmission error characteristic different (weight the transmission error characteristic) by making different the minimum Euclidean distance between subset symbols in the trellis-coded modulation scheme contained in each subset.

For example, in the universal set U of modulation symbols in a trellis coding modulator as shown in FIG. 4A, there are four subsets $u_0$ (symbols for $\bigcirc$), $u_1$ (symbols for $\square$), $u_2$ (symbols for $\triangle$), and $u_3$ (symbols for $\circledcirc$). Each subset can be divided into subsets as shown in FIGS. 5A, 5B, and 5C.

Here, 16 modulation symbols (one symbol: y3 y2 y1 y0) of FIG. 15A are used for transmission of the data string at hierarchic level L1 of the transmission channel; eight modulation symbols (one symbol: y2 y1 y0) of FIG. 5B are used for transmission of the data string at hierarchic level L2; and four modulation symbols (one symbol: y1 y0) of FIG. 5C are used for transmission of the data string at hierarchic level L3. It is known that use of a convolutional coding unit providing a sufficient distance between codes of FIG. 4B allows the transmission error characteristic to depend on (precisely approach gradually) the minimum value of the second Euclidean distance. Because $d2,i = \sqrt{2}d1,i$, this gives a characteristic as shown in FIG. 7.

In transmission of hierarchic level L3, because the bits to be used in transmission are transmitted in the form of only y0 and y1 coded bits of FIG. 4B, the transmission error characteristic depends on the configuration of the coding unit. For example, as shown in FIG. 7, the transmission error characteristic is 8 to 9 dB better in C/N than the characteristic of uncoding QPSK.

As described above, with the present invention, it is possible to weight the transmission of the data strings at the individual hierarchic levels of each transmission channel.

With the configuration of FIG. 3, a multilevel weighted transmission and reception apparatus with an improved transmission error characteristic can be realized by effecting a pair of trellis coding and decoding at the trellis coding unit 22 and trellis decoder 44. With the configuration, because each weighting is achieved by a pair of a trellis coding unit and a decoding unit, this helps reduce the size of the apparatus. This is because the convolutional coding process of each level of hierarchy shares the trellis coding unit and the trellis decoder is also shared by the individual hierarchic levels.

The first control circuit 26 and the second control circuit 46 of FIG. 3 time-division multiplexes hierarchic levels L1, L2, ..., Ln serving as n transmission channels in ascending order of the quality of transmission error characteristic (i.e., hierarchic levels L1, L2, ..., Ln). The reason for this is that when convolutional coding/decoding of each hierarchic level is divided with respect to time as shown in FIG. 12A and coding and decoding is effected serially, if transmission is started, beginning at the hierarchic level with the best transmission error characteristic toward that with a poorer characteristic, error propagation will take place in decoding. The reason why the error propagation takes place is that the decoding process is carried out using the continuity of the distance between codes.

To avoid the problem, by starting transmission, beginning at the hierarchic level with the worst transmission error characteristic toward that with a better characteristic, and then decoding the codes, error propagation will take place only when operation moves from hierarchic level L1 to hierarchic level Ln, thereby minimizing error propagation.

In FIG. 3, the data string at hierarchic level L1 of the transmission channel is {Le1, Ie1, Qe1, Id1, Qd1, Ld1}. The data string at hierarchic level L2 of the transmission channel is {Le2, Ie2, Qe2, Id2, Qd2, Ld2}.

With a method and a transmission and a reception apparatus according to the present invention, when operation moves from hierarchic level Li whose transmission error characteristic is good to hierarchic level Lj (i > j) whose transmission error characteristic is bad in given time-division multiplexing, the error propagation is prevented by adding a dummy block (dummy data or data with a poor error characteristic, such as part of the data in hierarchic level L1) to the rear end of the data string in the hierarchic level Li.

It is obvious that error propagation extends over at least as many symbols as there are in the restraint length in convolutional coding. A dummy block for at least as many symbols as correspond to the restraint length is added. To obtain a far better characteristic, a dummy block of the symbol component corresponding to the length of path (i.e., four to six times the computation window, normally the restraint length in Viterbi decoding) used in deciding the maximum likelihood path in Viterbi decoding is added. In Viterbi decoding, the dummy block is processed. Although the decoded symbols corresponding to the dummy block contain error propagation, the error propagation is completed in the period of the dummy block by providing a sufficient number of symbols for the dummy block.

With a method and a transmission and a reception apparatus according to the present invention, more reliable transmission and reception can be performed by transferring information on the multiplexing ratio in time-division multiplexing at each hierarchic level through hierarchic level Ln whose transmission error characteristic is the best.

With a method and a transmission and a reception apparatus according to the present invention, a frame synchronizing code is added in the period that n hierarchic levels of the transmission channel make a round, that is, the frame period at hierarchic level Ln whose transmission error characteristic is the best, and on the reception side, frame synchronization can be established using the frame synchronizing code.

FIGS. 14 and 30 show means for causing a frame information adding circuit 263 (containing a multiplexing ratio information adding circuit, a frame synchronization coding circuit, and a dummy block adding circuit) to add the multiplexing ratio information, frame synchronizing code, and dummy block (hereinafter, these three generally called frame information) to hierarchic level Ln (n = 3). FIG. 13 shows its transmission timing. On the reception side in FIGS. 15 and 31, a frame synchronizing circuit 461 establishes frame synchronization, a multiplexing ratio information sensing circuit 462 senses the multiplexing ratio information, and a timing control circuit 463 controls time-division multiplexing. Since decoding of convolutional codes (Viterbi decoding) does not contain the concept of blocks, the decoding process can be carried out before frame synchronization has been established (symbol synchronization has only to be established).

In this case, frame synchronization is added to the data string before trellis coding as shown in FIGS. 14 and 15 so that frame synchronization can be established using the data string after trellis decoding (after Viterbi decoding). Then, the effect of error correction can lend itself to establishing frame synchronization, with the result that frame synchronization can be established reliably.

At this time, the frame information adding circuit 263 may be provided at the input of any stage before the multiplexer 21 (represented by dotted lines in FIG. 14).

When it is provided in the input section of Le3 (hierarchic level whose transmission error characteristic is the best), frame synchronization can be established more reliably.

With a method and a transmission and a reception apparatus according to the present invention, by using a plurality of multilevel digital modulators as shown in FIG. 32, more reliable carrier reproduction and clock reproduction are possible.

In this system, because the number of uncoded bits in the trellis-coded modulation scheme is limited for each level of hierarchy and this limitation makes the transmission error characteristic of each hierarchic level different, it is possible to use a plurality of digital modulators differing in modulation level between hierarchic levels. Then, the carrier and clock reproduced at the lowest level (highest prior) digital modulator can be used as those at a higher level (lower prior) digital modulator.

For example, a third digital modulator 25c and a third digital modulator 41c are a modulator and a demodulator for QPSK data, where carrier reproduction and clock reproduction are easier and more reliable than those of higher-order multilevel 8-QAM and 16-QAM. Therefore, by setting the center frequencies f1, f2, and f3 of the digital modulation signals of the first, second, third digital modulators 25a, 25b, 25c at a simple integer ratio, the remaining f1 and f2 can be reproduced using carrier f3 reproduced at the third digital modulator 41c, which is simpler and more reliable than the first and second digital modulators 41a, 41b reproduce carries independently.

If the clocks for the input data strings in the first, second, and third digital modulators 25a, 25b, 25c are in synchronization, the clocks for the data strings Id1, Qd1, and Id2, Qd2 can be reproduced using the clock reproduced at the third digital modulator 41c, which is simpler and more reliable than the first and second digital modulators 41a, 41b reproduce carries independently.

With a method and a transmission and a reception apparatus according to the present invention, when punctured codes with different rates in FEC coding are used, by inserting dummy blocks, multilevel weighted transmission can be realized without error propagation.

## Claims

1. A multilevel weighted transmission method where on the transmission side, a plurality of hierarchic information source data strings are each subjected to different multilevel weighted coding and modulation and transmitted, and on the reception side, the received signal is subjected to the multilevel weighted demodulation and decoding corresponding to the transmission side to produce the original hierarchic information source data strings, said multilevel weighted transmission method characterized in that:

    a trellis-coded modulation scheme is used in coding and of the modulation symbols constituting a constellation for said modulation, m subsets defined in said trellis-coded modulation scheme are determined to be $u_0, u_1, ..., u_{m-1}$;

    the universal set U of said modulation symbols is determined to be $U = u_0 \cup u_1 \cup ... \cup u_{m-1}$;

    first subsets in the universal set U are determined to be $S_1, S_2, ..., S_n$;

    when each of the subsets in said trellis-coded modulation scheme is divided into n second subsets $S_{1,i}, S_{2,i}, ..., S_{n,i}$ (i = 0, 1, ..., m-1), the following expressions are met:

$$u_0 \supseteq S_{1,0}, \ u_0 \supset S_{2,0}, \ ..., \ u_0 \supset S_{n,0}$$
$$u_0 \supseteq S_{1,1}, \ u_1 \supset S_{2,1}, \ ..., \ u_1 \supset S_{n,1}$$
$$...$$
$$u_{m-1} \supseteq S_{1,m-1}, \ u_{m-1} \supset S_{2,m-1}, \ ..., \ u_{m-1} \supset S_{n,m-1};$$

    the Euclidean distances d1,i, d2,i, ..., dn,i (i = 0, 1, ..., m-1) between the modulation symbols contained in said second subsets $S_{1,i}, S_{2,i}, ..., S_{n,i}$ are determined to be d1,i < d2,i < ... < dn,i;

    said first subset $S_1, S_2, ..., S_n$ are determined to be:

$$S_1 = S_{1,0} \cup S_{1,1} \cup \cdots \cup S_{1,m-1}$$
$$S_2 = S_{2,0} \cup S_{2,1} \cup \cdots \cup S_{2,m-1}$$
$$\cdots$$
$$S_n = S_{n,0} \cup S_{n,1} \cup \cdots \cup S_{n,m-1};$$

the minimum Euclidean distances d1, d2 ..., dn between the modulation symbols contained in said first subsets $S_1$, $S_2$, ..., $S_n$ are determined to be d1 $\leq$ d2 $\leq$ ... $\leq$ dn; and

when $S_1$ to $S_n$ are allocated to the individual hierarchic levels of the transmission channel in said multilevel weighted transmission and said $S_1$ to $S_n$ are time-division multiplexed at a predetermined constant ratio and transmitted, the order of time-division multiplexing the hierarchic levels of said transmission channel is determined to be ascending order of the quality of transmission error characteristic.

2. A multilevel weighted transmission method according to claim 1, characterized in that when operation moves from a hierarchic level whose transmission error characteristic is good to a hierarchic level whose transmission error characteristic is bad, more than as many dummy blocks as (the number equivalent to the constraint length of convolutional codes - 1) are added to the rear end of the portion corresponding to the hierarchic level whose transmission error characteristic is good of said data string to be coded.

3. A multilevel weighted transmission method according to claim 1, characterized in that the hierarchic levels of said transmission channel are time-division multiplexed within a frame of data in ascending order of the quality of error characteristic of the transmission channel, said dummy blocks are added to the rear end of each frame, and the resulting frames are transmitted.

4. A multilevel weighted transmission method according to claim 2 or 3, characterized in that the size of said dummy blocks is more than several times as large as the constraint length of convolutional codes.

5. A multilevel weighted transmission method according to claim 1, characterized in that on said transmission side, information on the multiplexing ratio is added to the transmission route at a particular hierarchic level whose transmission error characteristic is the best of the hierarchic levels of said transmission channel and the transmission route at the hierarchic level of said transmission channel is time-division multiplexed at said multiplexing ratio and transmitted,

on the reception side, the information on the multiplexing ratio added to said particular hierarchic level is sensed and subjected to a decoding process at the hierarchic level of said transmission channel by means of a time-division process on the basis of the multiplexing ratio.

6. A multilevel weighted transmission method according to claim 1, characterized in that on the transmission side,

a frame synchronizing code is added in the period that the hierarchic levels of said transmission channel make a round to the transmission route at a particular hierarchic level whose transmission error characteristic is the best of the hierarchic levels of said transmission channel,

on the reception side, synchronization is established on the basis of said frame synchronizing code and subjected to a decoding process at the hierarchic level of said transmission channel by means of a time-division process in the synchronized state.

7. A multilevel weighted transmission method according to claim 1, characterized in that information on the individual hierarchic levels of said transmission channel is transmitted using a plurality of different multilevel modulation carriers.

8. A multilevel weighted transmission method according to claim 1, characterized in that information on the individual hierarchic levels of said transmission channel is transmitted using an OFDM (Orthogonal Frequency Division Multiplexer) modulation scheme.

9. A multilevel weighted transmission method according to claim 8, characterized in that the frame period of time-division multiplexing of the individual hierarchic levels of said transmission channel is equal to or 1/n (n is an integer) the transmission frame period of OFDM, said convolutional coding is of the feed forward type, and the size of said dummy blocks is (the number equivalent to the restraint length of convolutional codes - 1).

10. A multilevel weighted transmission method according to claim 1, characterized in that the coding that weights said individual hierarchic levels is punctured coding with different coding rates, the order of said time-division multiplexing is ascending order of the quality of transmission error characteristic of said punctured coded individual hierarchic levels, and more than as many dummy blocks as correspond to the restraint length of coding are added to the rear end of the hierarchic level whose transmission error characteristic is the best.

11. A multilevel weighted transmission apparatus which subjects a plurality of hierarchic information source data strings to different multilevel weighted coding and modulation and transmits the resulting strings, said multilevel weighted transmission apparatus characterized by comprising:
a multiplexer (21) which time-division multiplexes said plurality of information source data strings on the basis of a multiplexing ratio;
a trellis coding unit (22) which subjects the output of the multiplexer to trellis coding;
a plurality of signal mapping distributors (23, 23a, 23b, 23c) which, when the universal set of modulation symbols constituting a constellation of said modulation is divided into a plurality of subsets, are provided for each of the subsets, and outputs transmission signal mapping data specifying the modulation symbols contained in each of the subsets; and
control means (26) which determines the order of time-division multiplexing the hierarchic levels of said transmission channel to be ascending order of the quality of transmission error characteristic.

12. A multilevel weighted transmission apparatus according to claim 11, characterized by further comprising dummy block adding means (22) which, when operation moves from a hierarchic level whose transmission error characteristic is good to a hierarchic level whose transmission error characteristic is bad, adds more than as many dummy blocks as (the number equivalent to the constraint length of convolutional coding - 1) to the rear end of the portion corresponding to the hierarchic level whose transmission error characteristic is good of said data string not subjected to trellis coding.

13. A multilevel weighted transmission apparatus according to claim 11, characterized in that said control means (26) controls said multiplexer (21) to time-division multiplexes the data strings at the individual hierarchic levels in a frame in ascending order of the quality of error characteristic.

14. A multilevel weighted transmission apparatus according to claim 12, characterized in that said dummy block adding means (22) has the function of adding as many dummy blocks as more than twice said constraint length.

15. A multilevel weighted transmission apparatus according to claim 11, characterized by further comprising adding means (36) which adds information on the multiplexing ratio to the transmission route at a particular hierarchic level whose transmission error characteristic is the best of said hierarchic levels.

16. A multilevel weighted transmission apparatus according to claim 11, characterized by further comprising frame synchronization adding means (37) which adds a frame synchronizing code in the period that said hierarchic levels make a round to the transmission route at a particular hierarchic level whose transmission error characteristic is the best of said hierarchic levels.

17. A multilevel weighted transmission apparatus according to claim 11, characterized by further comprising a multiplexer (24) which forms the trellis coded data strings at said hierarchic levels outputted from said signal mapping distributors (23, 23a, 23b, 23c) into a single hierarchic level, and a digital modulator (35) which subjects the output of the multiplexer (24) to digital modulation and outputs the modulated signal.

18. A multilevel weighted transmission apparatus according to claim 17, characterized in that said digital modulator (35) is an OFDM modulator.

19. A multilevel weighted transmission apparatus according to claim 18, characterized in that said control means (26) sets the frame period of time-division multiplexing equal to or at 1/n (n is an integer) the frame period of said OFDM modulator (35), the convolutional coding contained in said trellis coding unit (22) is of the feed forward type, and said dummy block adding means adds as many dummy blocks as (the number equivalent to the restraint length of convolutional codes - 1) symbols.

20. A multilevel weighted transmission apparatus which subjects a plurality of hierarchic information source data strings to different multilevel weighted coding and modulation and transmits the resulting strings, said multilevel weighted transmission apparatus characterized by comprising:

a multiplexer (21) which time-division multiplexes said plurality of information source data strings on the basis of a multiplexing ratio;

a convolutional coding unit (29) which subjects the output of the multiplexer to convolutional coding;

punctured means (31a, 31b) which subjects the output of the convolutional coding unit (29) to a thinning-out process at specific ratios;

control means (26) which determines the order of time-division multiplexing the hierarchic levels of said transmission channel to be ascending order of the quality of transmission error characteristic; and

dummy block adding means (29) which adds more than as many dummy blocks as correspond to the constraint length of coding.

21. A multilevel weighted reception apparatus in a multilevel weighted transmission scheme where, on the transmission side, a plurality of hierarchic information source data strings are subjected to different multilevel weighted coding and modulation and the resulting strings are transmitted, and on the reception side, the received signal is subjected to the multilevel weighted demodulation and decoding according to the transmission side to obtain the original hierarchic information source data strings, said multilevel weighted reception apparatus characterized by comprising:

a plurality of signal mapping decoders (42a, 42b, 42c) which, when the demodulated signals are inputted and the universal set of the modulation symbols constituting a constellation of said modulation is divided into a plurality of subsets, output the decision data corresponding to the modulation symbols contained in each of said subsets;

a multiplexer (43) which receives said decision data outputted from said signal mapping decoders (42a, 42b, 42c), time-division multiplexes the data on the basis of a specific multiplexing ratio, outputs the multiplexed signal;

a trellis decoder (47) which subjects the output of the multiplexer (43) to trellis decoding;

a demultiplexer (45) which separates the output of the trellis decoder (44) into a plurality of hierarchic levels of the transmission channel on the basis of said multiplexing ratio; and

control means (46) which determines the order of decoding the data strings time-division multiplexed at the hierarchic levels to be ascending order of the quality of transmission error characteristic.

22. A multilevel weighted reception apparatus according to claim 21, characterized in that the dummy blocks added to the rear end of the portion corresponding to said hierarchic level whose transmission error characteristic is good is also subjected to the trellis decoding process.

23. A multilevel weighted reception apparatus according to claim 21, characterized in that said control means (46) establishes frame synchronization and controls said time-division multiplexing separation, and said trellis decoder (44) also subjects the dummy blocks added to the rear end of the frame to the trellis decoding process or the Viterbi decoding process.

24. A multilevel weighted reception apparatus according to claim 22 or 23, characterized in that the size of said dummy blocks is larger than the size of a path memory for Viterbi decoding.

25. A multilevel weighted reception apparatus according to claim 21, characterized in that said control means (46) contains multiplexing ratio information sensing means (462) which senses the multiplexing ratio information from the data string at a particular hierarchic level whose transmission error characteristic is the best of said hierarchic levels.

26. A multilevel weighted reception apparatus according to claim 21, characterized in that said control means (46) contains frame synchronizing means (461) which senses the frame synchronizing code from the data string at a particular hierarchic level whose transmission error characteristic is the best of said hierarchic levels.

27. A multilevel weighted reception apparatus according to claim 21, characterized in that said multilevel weighted demodulation is performed at a plurality of digital demodulators (41a, 41b, 41c) to which said received signal is supplied and whose multilevel differs.

28. A multilevel weighted reception apparatus according to claim 21, characterized in that said multilevel weighted demodulation is performed at an OFDM demodulator.

29. A multilevel weighted reception apparatus according to claim 28, characterized in that said control means (46) sets the frame period of the time-division multiplexing separation process equal to or at 1/n (n is an integer) the frame period of said OFDM demodulator;

said trellis decoder (44) contains a Viterbi decoder (442) suitable for feed-forward convolutional coding; and

characterized by further comprising means for inserting into the decoded output, as many dummy blocks as the number of the remaining symbols obtained by subtracting the number of symbols in the transmitted dummy blocks from the size (computation window) of the path memory of said Viterbi decoder (442).

30. A multilevel weighted reception apparatus according to claim 21, characterized by further comprising a depunctured circuit (48a, 48b, 48c) subjects the demodulated output in said multilevel weighted demodulation to a depunctured process and a Viterbi decoder (49) which Viterbi decodes the output.

F I G. 1

(TRANSMISSION SIGNAL)

(INFORMATION SOURCE SIGNAL OUTPUT)

20

28

25a 1ST DIGITAL MODULATOR

25b 2ND DIGITAL MODULATOR

Ie1 Qe1 Ie2 Qe2

23a 1ST SIGNAL MAPPING DISTRIBUTOR

23b 2ND SIGNAL MAPPING DISTRIBUTOR

39a 1ST FEC CODING UNIT

39b 2ND FEC CODING UNIT

Le1 Le2

WEIGHTING TRANSMISSION APPARATUS

11 INFORMATION SOURCE SIGNAL CODING UNIT

(INFORMATION SOURCE SIGNAL INPUT)

61 INFORMATION SOURCE SIGNAL DECODING UNIT

Ld1 Ld2

40

56a 1ST FEC DECODER

52b 2ND FEC DECODER

42a 1ST SIGNAL MAPPING DECODER

42b 2ND SIGNAL MAPPING DECODER

Id1 Qd1 Id2 Qd2

55a 1ST DIGITAL DEMODULATOR

55b 2ND DIGITAL DEMODULATOR

WEIGHTING RECEPTION APPARATUS

(RECEPTION SIGNAL)

23

FIG. 2

f1 : CARRIER FREQUENCY OF 1ST DIGITAL MODULATOR
f2 : CARRIER FREQUENCY OF 2ND DIGITAL MODULATOR
F1 : SPECTRUM OF OUTPUT SIGNAL OF 1ST DIGITAL MODULATOR
F2 : SPECTRUM OF OUTPUT SIGNAL OF 2ND DIGITAL MODULATOR

FIG. 4A

$(xxy_1y_1)$

○ : (xx00), $S_{1,0}$=U0
□ : (xx01), $S_{1,1}$=U1
△ : (xx10), $S_{1,2}$=U2
◎ : (xx11), $S_{1,3}$=U3

UNIVERSAL U=$S_{1,0}$U $S_{1,1}$U $S_{1,2}$U $S_{1,3}$

FIG. 4B

x3 → y3
x2 → y2
} UNCODED BITS

x1 → CONVOLUTIONAL CODING UNIT → y1, y0
} CODED BITS

CODING RATE = 1/2

WEIGHTING TRANSMISSION APPARATUS

1ST CONTROL CIRCUIT 26

1ST SIGNAL MAPPING DISTRIBUTOR 23a

2ND SIGNAL MAPPING DISTRIBUTOR 23b

3RD SIGNAL MAPPING DISTRIBUTOR 23c

INFORMATION SOURCE SIGNAL CODING UNIT 111

TRELLIS CODING UNIT 22

DIGITAL MODULATOR 25

(INFORMATION SOURCE SIGNAL INPUT) (INFORMATION SOURCE)

(TRANSMISSION SIGNAL)

WEIGHTING RECEPTION APPARATUS

1ST SIGNAL MAPPING DECODER 42a

2ND SIGNAL MAPPING DECODER 42b

3RD SIGNAL MAPPING DECODER 42c

DIGITAL DEMODULATOR 41

TRELLIS DECODER 44

2ND CONTROL CIRCUIT 46

INFORMATION SOURCE SIGNAL DECODING UNIT 61

(RECEPTION SIGNAL)

(INFORMATION SOURCE SIGNAL OUTPUT)

F I G. 3

EP 0 702 476 A2

$\bigcirc$ : SUBSET WHOSE 2 LEAST SIGNIFICANT BITS ARE "00"

$\times$ : SUBSET WHOSE 2 LEAST SIGNIFICANT BITS ARE OTHER THAN "00"

$\bullet$ : UNUSED SYMBOL

$d1,0 = 2d$

$S_1$ AND TRANSMISSION DATA
(ONLY $S_{1,0}$)
(HIERARCHIC LEVEL L1)

## F I G. 5A

$d2 = \sqrt{2}\,d$
$d2,0 = \sqrt{8}\,d$

$S_2$ AND TRANSMISSION DATA
(ONLY $S_{2,0}$)
(HIERARCHIC LEVEL L2)

## F I G. 5B

$d3,i = \infty \quad i = 0,1,2,3$

$S_3$ AND TRANSMISSION DATA
(HIERARCHIC LEVEL L3)

## F I G. 5C

EP 0 702 476 A2

$(xy1,y0)$
$\bigcirc : (x00), S_{2,0}$
$\square : (x01), S_{2,1}$
$\triangle : (x10), S_{2,2}$
$\circledcirc : (x11), S_{2,3}$

(a) MAPPING WITH HAMMING DISTANCE BETWEEN ADJACENT SYMBOLS AS SMALL AS POSSIBLE

$d2 = \sqrt{2}d$

$d$

UNCODED BIT :
$y2 = x2$

0
$\circledcirc$
$(011)$

$\bigcirc$
$(100)$

$d2,0 = \sqrt{8}d$

1
$\square$
$(101)$

0
$\triangle$
$(010)$

$d2,2 = \sqrt{8}d$

Q

I

0
$\bigcirc$
$(000)$

1
$\circledcirc$
$(111)$

1
$\triangle$
$(110)$

0
$\square$
$(001)$

F I G. 6A

UNUSED SYMBOL

(b) MAPPING WITH 180° PHASE INVARIANT

0
$\triangle$
$(010)$

1
$\bigcirc$
$(100)$

1
$\square$
$(101)$

0
$\circledcirc$
$(011)$

0
$\bigcirc$
$(000)$

1
$\triangle$
$(110)$

1
$\circledcirc$
$(111)$

0
$\square$
$(001)$

F I G. 6B

UNCODED QPSK

UNCODED 16—QAM

SYMBOL ERROR RATE

8~9dB          7dB
6~7dB          6dB
L3      L2      L1
3dB
C/N [dB]

ERROR RATE CHARACTERISTIC FOR EACH
HIERARCHIC LEVEL

## F I G. 7

| ADDRESS<br>A2 A1 A0 | OUTPUT DATA<br>D3 D2 D1 D0 |
|---|---|
| 0 0 0 | 0 0 0 0 |
| 0 0 1 | 1 0 1 1 |
| 0 1 0 | 0 0 1 1 |
| 0 1 1 | 1 0 0 0 |
| 1 0 0 | 1 1 0 0 |
| 1 0 1 | 0 1 1 1 |
| 1 1 0 | 1 1 1 1 |
| 1 1 1 | 0 1 0 0 |

## F I G. 10

F I G. 8

TRANSMISSION APPARATUS

F I G. 9

EP 0 702 476 A2

R: INFORMATION ON GROUP OF REPRESENTATIVE SYMBOLS IN SUBSET

$\lambda$: BRANCH METRIC (3BITS × 4)

F I G. 11    RECEPTION APPARATUS

FRAME PERIOD

DECODING TIME

COMPUTATION WINDOW OF VITERBI DECODING

L2 | L1 | L3 | L2 | L1

L2 | L1 | L3 | L2

ERROR PROPAGATION TAKES PLACE

ERROR PROPAGATION IN MULTIPLEXING
WHEN MOVING FROM HIERARCHIC LEVEL WHOSE ERROR
CHARACTERISTIC IS GOOD TO THAT WITH BAD CHARACTERISTIC :
ERROR RATE ( PL1>PL2>PL3 )

F I G. 12A

FRAME PERIOD

DECODING TIME

COMPUTATION WINDOW OF VITERBI DECODING

DUMMY BLOCKS

L1 | L2 | L3 | L1 | L2

L1 | L2 | L3 | L1

POINT OF MULTIPLEXING
INSERTION OF DUMMY BLOCKS PREVENTS ERROR PROPAGATION :
ERROR RATE ( PL1 > PL2>PL3 )

F I G. 12B

EP 0 702 476 A2

1 FRAME

Ie3/Qe3

Ic/Qe

| | Ie1/Qe1 | Ie2/Qe2 | |

Id/Qd

| | Id1/Qd1 | Id2/Qd2 | |

d3/Qd3

| (3) | (1) | (2) | (3) | (1) |

Td

| (3) | (1) | (2) | (3) | (1) |

A B C D

A : MULTIPLEXING RATIO INFORMATION
B : FRAME SYNCHRONIZING SIGNAL
C : ORIGINAL INFORMATION SOURCE DATA STRING
D : DUMMY BLOCK

F I G. 13

BOUNDARY OF AREA
EFFECTIVE SYMBOL

(G) (H) (I)

(D) (E) (F) → I

(A) (B) (C)

(NO. OF AREAS : 9)

S1 AREA DECISION

F I G. 16A

(F)

(E) (C)

(D) (B) → I

(A)

(NO. OF AREAS : 6)

S2 AREA DECISION

F I G. 16B

TRANSMISSION APPARATUS

F I G.  14

EP 0 702 476 A2

34

F I G. 15

RECEPTION APPARATUS

EP 0 702 476 A2

UNCODED BIT DECODING
CIRCUIT

49

43

R1 4
λ1 12 ① 

R2 3 ②
λ2 12

X ③
λ3

R

λ

492

DELAY
CIRCUIT

4

4 3

1ST
DECODER
ROM

493

2ND
DECODER
ROM

494

45

① Ld1

X ② Ld2

③ Ld3

(DECODED CODED
BITS)

2

12

VITERBI DECODING
CIRCUIT

491

VITERBI CODED
BITS

TRELLIS DECODER

46 2ND CONTROL
CIRCUIT

F I G. 17

RECEPTION APPARATUS

EP 0 702 476 A2

36

FIG. 18

(BER CHARACTERISTIC IN EACH MODE ALONE : PART 1 )

F I G. 19

(ACTUAL WEIGHTING BER CHARACTERISTIC MULTIPLEXING RATIO ：)
(3000 ： 2000 ： 1000 DUMMY BLOCK SIZE ： Ds = 0 )

F I G. 20 (ACTUAL WEIGHTING BER CHARACTERISTIC MULTIPLEXTING RATIO :)
(3000 : 2000 : 1000 DUMMY BLOCK SIZE : Ds = 8 )

EP 0 702 476 A2

F I G. 21

( ACTUAL WEIGHTING BER CHARATERISTIC MULTIPLEXING RATIO : )
( 3000 : 2000 : 1000 DUMMY BLOCK SIZE : Ds = 32 )

F I G. 22 ( ACTUAL WEIGHTING BER CHARACTERISTIC MULTIPLEXING RATIO : )
(3000 : 2000 : 1000 DUMMY BLOCK SIZE : DS = 0 TO 32 )

EXAMPLE OF SIGNAL ARRANGEMENT OF
HIERARHIC LEVEL L2

F I G. 23

F I G. 26

TRANSMISSION APPARATUS

FIG. 24

EP 0 702 476 A2

F I G. 25　( BER CHARACTERISTIC IN EACH MODE ALONE : PART 2 )

EP 0 702 476 A2

FIG. 27

WEIGHTING TRANSMISSION APPARATUS

WEIGHTING RECEPTION APPARATUS

FIG. 28

EP 0 702 476 A2

F I G. 29

F I G. 30

EP 0 702 476 A2

FIG. 31

EP 0 702 476 A2

EP 0 702 476 A2

1ST CONTROL CIRCUIT — 26 (SIGNAL FOR MULTIPLEXING-TIMING)

(INFORMATION SOURCE) (INFORMATION SOURCE SIGNAL INPUT)

11 INFORMATION SOURCE SIGNAL CODING UNIT

Le1
Le2
Le3

21 ① ② ③

27 EXTERNAL FEC CODING UNIT

22 TRELLIS CODING UNIT

23a 1ST SIGNAL MAPPING DISTRIBUTOR
23b 2ND SIGNAL MAPPING DISTRIBUTOR
23c 3RD SIGNAL MAPPING DISTRIBUTOR

Ie1 Qe1
Ie2 Qe2
Ie3 Qe3

25a 1ST DIGITAL MODULATOR
25b 2ND DIGITAL MODULATOR
25c 3RD DIGITAL MODULATOR

28

(TRANSMISSION SIGNAL)

WEIGHTING TRANSMISSION APPARATUS

(RECEPTION SIGNAL)

41a 1ST DIGITAL DEMODULATOR
41b 2ND DIGITAL DEMODULATOR
41c 3RD DIGITAL DEMODULATOR

Id1 Qd1
Id2 Qd2
Id3 Qd3

42a 1ST SIGNAL MAPPING DECODER
42b 2ND SIGNAL MAPPING DECODER
42c 3RD SIGNAL MAPPING DECODER

43 ① ② ③

44 TRELLIS DECODER

47 EXTERNAL FEC DECODER

45 ① ② ③

Ld1
Ld2
Ld3

61 INFORMATION SOURCE SIGNAL DECODING UNIT

(INFORMATION SOURCE SIGNAL OUTPUT)

46 2ND CONTROL CIRCUIT

40

WEIGHTING RECEPTION APPARATUS

F I G. 32

MULTIPLEXING RATIO OF L1,L2,L3, 3:2:1

OUTPUT OF TRELLIS
CODING UNIT :

| | L1 | L2 | L3 | L1 | L2 | L3 | | ···Rs |

L1 ;Ie1/Qe1  ··· 3/6Rs

L2 ;Ie2/Qe2  ··· 2/6Rs

L3 ;Ie3/Qe3  ··· 1/6Rs

SYMBOL

F I G. 33A

SPECTRUM

L3   L2   L1

f

1/6Rs   2/6Rs   3/6Rs

F I G. 33B

EP 0 702 476 A2

F I G. 34

CONVOLUTIONAL CODING UNIT

$r = \frac{1}{2}$  $r = \frac{1}{3}$

## F I G. 35

TRANSMISSION SIDE

FRAME PULSE

TRELLIS CODED INPUT — L1 L2 L3

TRELLIS CODED OUTPUT — L1 L2 L3

DUMMY BLOCK (6 SYMBOLS)

TRANSMISSION DATA RANGE

COMPUTATION WINDOW OF VITERBI DECODING

RECEPTION SIDE

FRAME PULSE

Id/Qd — L1 L2 L3

TRANSMITTED DUMMY BLOCK

(DUMMY BLOCK INSERTED ON THE RECEPTION SIDE)

## F I G. 36

F I G. 37

(TRANSMISSION SIGNAL)

20
25 DIGITAL MODULATOR
Ie / Qe
23 SIGNAL MAPPING DISTRIBUTOR
24
① ② ③
26 1ST CONTROL CIRCUIT
31a 1ST PUNCTURE CIRCUIT
31b 2ND PUNCTURE CIRCUIT
29 CONVOLUTIONAL CODING UNIT
21 ① ② ③
Le1 Le2 Le3
11 INFORMATION SOURCE SIGNAL CODING UNIT
(INFORMATION SOURCE SIGNAL INPUT)

WEIGHTING TRANSMISSION APPARATUS

(INFORMATION SOURCE SIGNAL OUTPUT)
61 INFORMATION SOURCE SIGNAL DECODING UNIT
40
45 ① ② ③
49 VITERBI DECODER
46 2ND CONTROL CIRCUIT
43 ① ② ③
48a 1ST DEPUNCTURE CIRCUIT
48b 2ND DEPUNCTURE CIRCUIT
48c SIGNAL MAPPING DECODER
Id / Qd
41 DIGITAL DEMODULATOR
(RECEPTION SIGNAL)

WEIGHTING RECEPTION APPARATUS

54

FIG. 38  BER CHARACTERISTIC OF EACH HIERARCHIC LEVEL ALONE
(WITHOUT MULTIPLEXING)

EP 0 702 476 A2

F I G. 39

MULTIPLEXING CHARACTERISTIC
(MULTIPLEXING IN DESCENDING ORDER OF QUALITY OF
ERROR CHARACTERISTIC WITHOUT DUMMY BLOCKS )

EP 0 702 476 A2

FIG. 40

MULTIPLEXING CHARACTERISTIC
(MULTIPLEXING IN ASCENDING ORDER OF QUALITY OF ERROR CHARACTERISTIC WITHOUT DUMMY BLOCKS)

EP 0 702 476 A2

F I G. 4 1